# EUROPEAN PATENT SPECIFICATION

(11) **EP 4 498 429 B1**
(45) Date of publication and mention of the grant of the patent: **24.06.2026**
(21) Application number: 22940203.7
(22) Date of filing: 28.04.2022
(51) Int. Cl.: H10W 44/20, H10W 90/00, H10W 90/10, H10W 90/20, H10W 70/65, H10W 70/68, H10W 40/22

(54) **SEMICONDUCTOR DEVICE**
HALBLEITERANORDNUNG
DISPOSITIF À SEMI-CONDUCTEUR

(43) Date of publication of application: 29.01.2025
(73) Proprietor: MITSUBISHI ELECTRIC CORPORATION, Chiyoda-ku Tokyo 100-8310 (JP)
(72) Inventor: NISHIMURA, Takuma, Tokyo 100-8310 (JP); KOMATSUZAKI, Yuji, Tokyo 100-8310 (JP); NAGAMINE, Takumi, Tokyo 100-8310 (JP); YUKAWA, Hidenori, Tokyo 100-8310 (JP); FUKASAWA, Toru, Tokyo 100-8310 (JP)
(74) Representative: Pfenning, Meinig & Partner mbB
(86) International application number: PCT/JP2022/019216
(87) International publication number: WO 2023/209926

(56) References cited:
- WO-A1-2020/012598
- JP-A- 2001 111 232
- JP-A- 2004 006 757
- JP-A- 2005 251 898
- JP-A- 2006 270 098
- JP-A- 2019 145 760
- JP-A- H0 537 208
- US-A1- 2003 122 638
- US-A1- 2010 102 443
- US-A1- 2018 061 725

## Description

### TECHNICAL FIELD

The present disclosure relates to a semiconductor device on which a semiconductor element is mounted.

### BACKGROUND ART

In the field of high frequency devices for communication and the like, a small and low power consumption semiconductor device on which a semiconductor element that is a high-power amplifier is mounted has been proposed by Patent Literature 1.

The semiconductor device disclosed in Patent Literature 1 is a semiconductor device including a thick copper member on a back surface, an opening arranged on a front surface of the thick copper member, a printed circuit board including a wiring pattern on a front surface, and a semiconductor chip mounted on the front surface of the thick copper member exposed by an opening of the printed circuit board, the semiconductor chip processing and outputting a high frequency signal.

The semiconductor device disclosed in Patent Literature 2 is an air-cavity semiconductor package with enhanced package integration level and thermal performance.

### CITATION LIST

### PATENT LITERATURES

Patent Literature 1: WO 2020/012598 A1
Patent Literature 2: US 2018/0061725 A1

### SUMMARY OF INVENTION

### TECHNICAL PROBLEM

Since the semiconductor device disclosed in Patent Literature 1 uses a thick copper member having good heat diffusibility, there is an advantage that heat diffusibility is good, and heat generated in the semiconductor chip can be dissipated to the thick copper member, so that heat dissipation is excellent.

However, in the field of communication and the like, a wider band has been further developed, and further miniaturization and improvement of a heat dissipation effect are desired in a semiconductor device even when a complicated high frequency circuit is mounted.

The present invention has been made in view of the above points, and an object thereof is to obtain a semiconductor device that exhibits favorable characteristics even for wider bandwidth, is compact, and has an improved heat dissipation effect.

### SOLUTION TO PROBLEM

A semiconductor device according to the present invention includes: a first substrate including a first insulating substrate, a first wiring pattern layer and a plurality of first front-side pads formed on a front surface of the first insulating substrate; and a first base portion constituted by copper having a thickness of 100 µm or more and formed on a back surface of the first insulating substrate, wherein a first opening reaching a front surface of the first base portion from the front surface is formed in the first insulating substrate; a first semiconductor element mounted and fixed on the front surface of the first base portion of the first substrate via a first heat sink in the first opening of the first substrate, and electrically connected to a line implemented in the first wiring pattern layer of the first substrate, the line being connected to one of the plurality of first front-side pads; a second substrate including a second insulating substrate; a second wiring pattern layer and a plurality of second front-side pads formed on a front surface of the second insulating substrate, and a second base portion constituted by copper having a thickness of 100 µm or more and formed on a back surface of the second insulating substrate, wherein a second opening reaching a front surface of the second base portion from the front surface is formed in the second insulating substrate; a second semiconductor element mounted and fixed on the front surface of the second base portion of the second substrate via a second heat sink in the second opening of the second substrate, and electrically connected to a line implemented in the second wiring pattern layer of the second substrate, the line being connected to one of the plurality of second front-side pads; and a third substrate, which relays electrical connection between the first substrate and the second substrate, arranged between the first substrate and the second substrate in such a manner as to face the first substrate and the second substrate, the third substrate including a plurality of third back-side pads on a back surface, each of the third back-side pads being connected to a corresponding one of the plurality of first front-side pads of the first substrate by a connection member, and a plurality of third front-side pads on a front surface, each of the third front-side pads being connected to a corresponding one of the plurality of second front-side pads of the second substrate by a connection member, wherein the third substrate has a ground layer that is a solid pattern on each of the front surface and the back surface.

### ADVANTAGEOUS EFFECTS OF INVENTION

According to the present invention, since the first substrate having the thick copper base portion on which the first semiconductor element is arranged on the front surface, the second substrate having the thick copper base portion on which the front surface is arranged to face the front surface of the first substrate and the second semiconductor element is arranged on the front surface, and the third substrate arranged between the first substrate and the second substrate are stacked, the size is small, and the heat dissipation effect can be improved.

### BRIEF DESCRIPTION OF DRAWINGS

FIG. 1 is a cross-sectional view illustrating a semiconductor device according to a first embodiment.
FIG. 2 is a schematic diagram of the semiconductor device according to the first embodiment as viewed from a front surface of a first substrate.
FIG. 3 is a schematic diagram illustrating a connection relationship between a first semiconductor element and a wiring layer on the front surface of the first substrate, in the semiconductor device of the first embodiment.
FIG. 4 is a diagram illustrating a resist on a front surface layer of the first substrate of the semiconductor device according to the first embodiment.
FIG. 5 is a rear view of the semiconductor device according to the first embodiment projected from the front surface of the first substrate.
FIG. 6 is a schematic diagram of the semiconductor device according to the first embodiment as viewed from a front surface of a second substrate.
FIG. 7 is a schematic diagram illustrating a connection relationship between a second semiconductor element and a third semiconductor element and a wiring layer on the front surface of the second substrate, in the semiconductor device of the first embodiment.
FIG. 8 is a diagram illustrating a resist on a front surface layer of the second substrate of the semiconductor device according to the first embodiment.
FIG. 9 is a rear view of the semiconductor device according to the first embodiment projected from the front surface of the second substrate.
FIG. 10 is a diagram illustrating a conductor pattern on a front surface of a first layer in a third substrate of the semiconductor device according to the first embodiment.
FIG. 11 is a diagram illustrating a resist on the front surface of the first layer in the third substrate of the semiconductor device according to the first embodiment.
FIG. 12 is a diagram illustrating a conductor pattern on a front surface of a second layer in the third substrate of the semiconductor device according to the first embodiment.
FIG. 13 is a diagram illustrating a conductor pattern on a front surface of a third layer in the third substrate of the semiconductor device according to the first embodiment.
FIG. 14 is a diagram illustrating a conductor pattern on a front surface of a fourth layer in the third substrate of the semiconductor device according to the first embodiment.
FIG. 15 is a diagram illustrating a conductor pattern on a front surface of a fifth layer in the third substrate of the semiconductor device according to the first embodiment.
FIG. 16 is a diagram illustrating a conductor pattern on a back surface of a sixth layer in the third substrate of the semiconductor device according to the first embodiment.
FIG. 17 is a diagram illustrating a resist on the back surface of the sixth layer in the third substrate of the semiconductor device according to the first embodiment.
FIG. 18 is a cross-sectional view illustrating a semiconductor device according to a second embodiment.
FIG. 19 is a cross-sectional view illustrating a semiconductor device according to a third embodiment.
FIG. 20 is a cross-sectional view illustrating a semiconductor device according to a fourth embodiment.
FIG. 21 is a schematic diagram of the semiconductor device according to the fourth embodiment as viewed from a front surface of a first substrate.
FIG. 22 is a schematic diagram illustrating a connection relationship between a first semiconductor element and a wiring layer on the front surface of the first substrate, in the semiconductor device of the fourth embodiment.
FIG. 23 is a diagram illustrating a resist on a front surface layer of the first substrate of the semiconductor device according to the fourth embodiment.
FIG. 24 is a rear view of the semiconductor device according to the fourth embodiment projected from the front surface of the first substrate.
FIG. 25 is a schematic diagram of the semiconductor device according to the fourth embodiment as viewed from a front surface of a second substrate.
FIG. 26 is a schematic diagram illustrating a connection relationship between a second semiconductor element and a wiring layer on the front surface of the second substrate, in the semiconductor device of the fourth embodiment.
FIG. 27 is a diagram illustrating a resist on a front surface layer of the second substrate of the semiconductor device according to the fourth embodiment.
FIG. 28 is a rear view of the semiconductor device according to the fourth embodiment projected from the front surface of the second substrate.
FIG. 29 is a diagram illustrating a conductor pattern of a front surface layer in a third substrate of the semiconductor device according to the fourth embodiment.
FIG. 30 is a diagram illustrating a resist on a front surface of the front surface layer in the third substrate of the semiconductor device according to the fourth embodiment.
FIG. 31 is a diagram illustrating a conductor pattern of a back surface layer projected from a front surface in the third substrate of the semiconductor device according to the fourth embodiment.
FIG. 32 is a diagram illustrating a resist on a back surface of the back surface layer in the third substrate of the semiconductor device according to the fourth embodiment.

### DESCRIPTION OF EMBODIMENTS

### First Embodiment

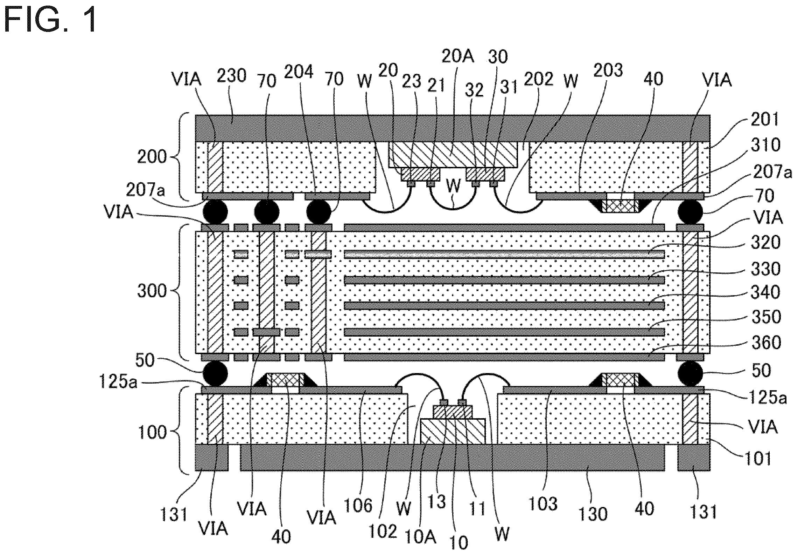

A semiconductor device according to a first embodiment will be described with reference to FIGS. 1 to 17.

The semiconductor device according to the first embodiment is a semiconductor device that is used in a high frequency device for communication or the like and is constituted by a stacked package in which a semiconductor element having a high output amplification function, a semiconductor element having a power supply control function, and a semiconductor element having a driver amplification function are mounted.

The semiconductor device according to the first embodiment is particularly a semiconductor device with high reliability and good manufacturability while achieving ultra-wideband characteristics that can substantially cover the entire region of the Sub-6 band (band of 3.6 GHz or more and less than 6 GHz).

As illustrated in FIG. 1, the semiconductor device according to the first embodiment includes a first semiconductor element 10, a second semiconductor element 20, a third semiconductor element 30, a first substrate 100, a second substrate 200, and a third substrate 300.

The first semiconductor element 10 is a semiconductor element having a high output amplification function. The first semiconductor element 10 includes two amplifier circuits. The first semiconductor element 10 is a semiconductor element that easily generates heat. The characteristic impedance of the first semiconductor element 10 is, for example, 100 Ω system.

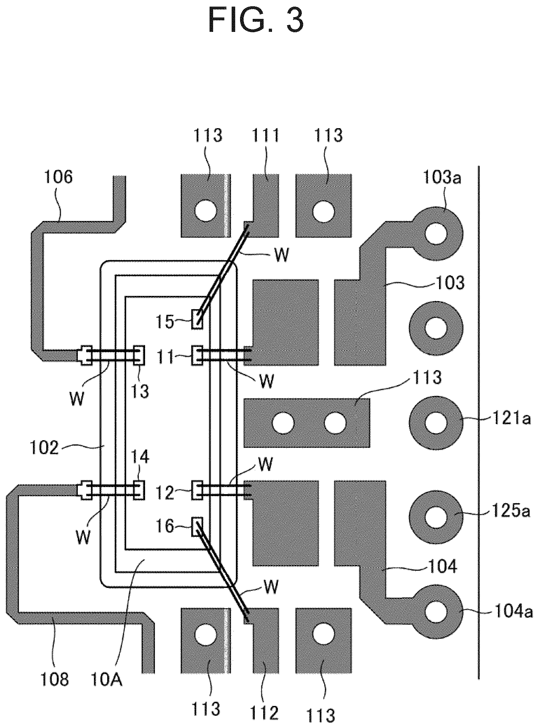

As illustrated in FIG. 3, the first semiconductor element 10 is a semiconductor chip having two input terminals 11 and 12, two output terminals 13 and 14, and two bias terminals 15 and 16 on a front surface of a semiconductor substrate, in which a back surface of the semiconductor substrate is a ground layer.

Each terminal 11 to 16 is a pad formed on the front surface of the semiconductor substrate.

The first substrate 100 includes a first insulating substrate 101 constituted by a single-layer insulating base material, a first wiring pattern layer and a plurality of first front-side pads formed on a front surface of the first insulating substrate 101, a first base portion 130 constituted by thick copper and a plurality of first back-side pads formed on a back surface of the first insulating substrate 101, and a first opening 102 reaching the front surface of the first base portion 130 from the front surface is formed in the first insulating substrate 101.

The first semiconductor element 10 is mounted on the first opening 102 with a first heat sink 10A interposed therebetween.

The ground layer on the back surface of the first semiconductor element 10 is grounded by the first base portion 130, and heat generated by the first semiconductor element 10 is dissipated via the first heat sink 10A and the first base portion 130.

Since the thickness of the first insulating substrate 101 is a thickness up to the manufacturing limit for forming the first opening 102, a high-impedance line can be implemented as a line in the first wiring pattern layer formed on the front surface of the first insulating substrate 101.

The first wiring pattern layer is formed by patterning a conductor that is a copper foil having a thickness of, for example, 18 um or 35 um, and includes a transmission line that transmits a signal, a power supply line that supplies power (current) from a power supply, a bias line that supplies a bias potential, and a GND line set to a ground potential.

The first wiring pattern layer constitutes a part of a high frequency package or a high frequency module incorporating a high frequency circuit by the first semiconductor element 10 and a chip component 40 (only a part thereof is illustrated) such as a chip capacitor mounted by being electrically connected to a line constituting the first wiring pattern.

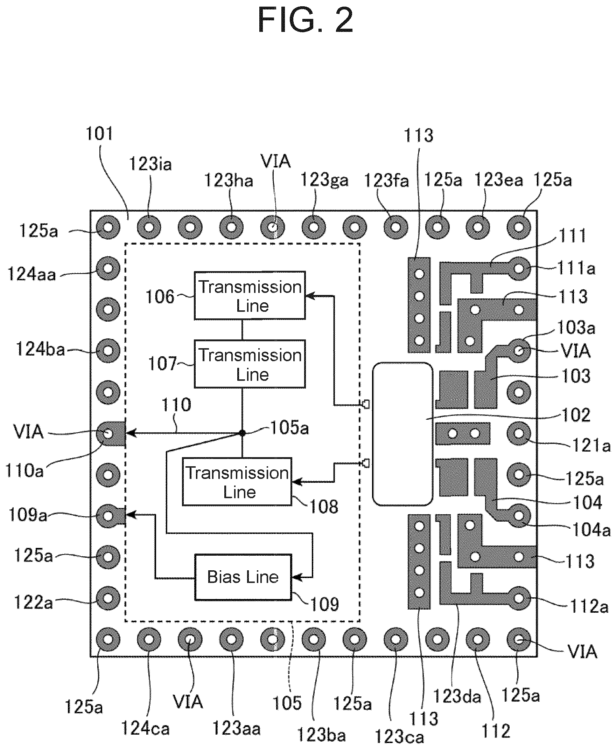

As illustrated in FIGS. 2 and 3, the first wiring pattern layer includes two input lines 103 and 104, a first transmission line 106 to a third transmission line 108 constituting an output synthesis circuit 105, a bias line 109, an output line 110, two bias lines 111 and 112, and a plurality of GND lines 113.

As illustrated in FIG. 3, one input line 103 is connected to one input terminal 11 of the first semiconductor element 10 by wire bonding using a wire W such as a gold wire.

The number of wires W is illustrated in units of two in FIG. 3, but may be one or three or more.

The number of wires W for wire bonding described below may be two, one, or three or more.

"One input line 103" is a collective term that refers to a line extending from a position to which one input terminal 11 of the first semiconductor element 10 is connected, to one input pad 103a, and when a chip component (not illustrated) such as a chip capacitor is connected in the middle, one input circuit is configured. One input circuit in this case is a generally known input circuit.

As illustrated in FIG. 3, the other input line 104 is connected to the other input terminal 12 of the first semiconductor element 10 by wire bonding using a wire W such as a gold wire.

"The other input line 104" is a collective term that refers to a line extending from a position to which the other input terminal 12 of the first semiconductor element 10 is connected, to another input pad 104a, and when a chip component (not illustrated) such as a chip capacitor is connected in the middle, the other input line constitutes the other input circuit. The other input circuit in this case is a generally known input circuit.

Each of the first transmission line 106 to the third transmission line 108 is a line having a high impedance of, for example, 100 Ω as a characteristic impedance and an electrical length of 50 degrees to 90 degrees.

Note that, in the present disclosure, 100 Ω does not strictly indicate only 100 Ω, and includes a value in a range allowed in design for 100 Ω.

Further, in the present disclosure, 50 degrees to 90 degrees do not strictly indicate only 50 degrees to 90 degrees, and include values in a range allowed by design for 50 degrees to 90 degrees.

As illustrated in FIG. 3, one end of the first transmission line 106 is connected to one output terminal 13 of the first semiconductor element 10 by wire bonding using a wire W such as a gold wire.

One end of the second transmission line 107 is connected to the other end of the first transmission line 106, and the other end is connected to an output node 105a of the output synthesis circuit 105.

The first transmission line 106 and the second transmission line 107 are lines that are connected in series between the one output terminal 13 of the first semiconductor element 10 and the output node 105a of the output synthesis circuit 105, and transmit a high-frequency amplified signal output from the one output terminal 13 of the first semiconductor element 10 to the output node 105a.

As illustrated in FIG. 3, one end of the third transmission line 108 is connected to the other output terminal 14 of the first semiconductor element 10 by wire bonding with wires W such as gold wires, and the other end is connected to the output node 105a of the output synthesis circuit 105.

The third transmission line 108 is a line that transmits the high-frequency amplified signal output from the other output terminal 14 of the first semiconductor element 10 to the output node 105a.

One end of the bias line 109 is connected to the output node 105a of the output synthesis circuit 105, and the other end is connected to a bias pad 109a.

"The bias line 109" is a collective term that refers to a line extending from the output node 105a of the output synthesis circuit 105 to the bias pad 109a, and a chip component (not illustrated) is connected in the middle to configure a bias circuit on the output side. The bias circuit is a generally known circuit.

The output line 110 is a line connected between the output node 105a of the output synthesis circuit 105 and an output pad 110a.

Since the output synthesis circuit 105 is configured using the first transmission line 106 to the third transmission line 108 having a high impedance as a characteristic impedance around 100 Ω, it is not necessary to use a matching circuit between the first semiconductor element 10 having a characteristic impedance of a 100 Ω system and the output pad 110a to which the 50 Ω line system is connected, and it is possible to implement ultra-wide band characteristics and downsize as a semiconductor device.

In addition, since the output synthesis circuit 105 is configured using the first transmission line 106 to the third transmission line 108 having an electrical length of about 50 degrees to 90 degrees, it is possible to efficiently switch the amplification mode of the first semiconductor element 10 using a difference in phase difference for each frequency.

As illustrated in FIG. 3, one bias line 111 is connected to one bias terminal 15 of the first semiconductor element 10 by wire bonding using wires W.

"One bias line 111" is a collective term that refers to a line extending from a position to which one bias terminal 15 of the first semiconductor element 10 is connected, to one bias pad 111a, and when a chip component (not illustrated) such as a chip capacitor is connected in the middle, the one bias line constitutes a bias circuit on one input side. One bias circuit in this case is a generally known bias circuit.

As illustrated in FIG. 3, the other bias line 112 is connected to the other bias terminal 16 of the first semiconductor element 10 by wire bonding using wires W.

"The other bias line 112" is a collective term that refers to a line extending from a position to which the other bias terminal 16 of the first semiconductor element 10 is connected, to the other bias pad 112a, and when a chip component (not illustrated) such as a chip capacitor is connected in the middle, the other bias line constitutes a bias circuit on the other input side. The other bias circuit in this case is a generally known bias circuit.

As illustrated in FIGS. 2 and 3, each of the plurality of GND lines 113 is arranged between adjacent transmission lines to prevent interference between signals or the like between the adjacent transmission lines.

Each of the plurality of GND lines 113 is electrically connected to the first base portion 130 formed on the back surface of the first insulating substrate 101 by a via (VIA) indicated by marks o in FIG. 2 in the GND line 113.

Note that, among the plurality of GND lines 113, the GND line 113 that extends to the side of the first insulating substrate 101 and has a line width wider than the diameter of the pad also serves as a GND pad 113a whose end is connected to the via VIA.

In the present example, the plurality of front-side pads formed on the front surface of the first insulating substrate 101 is formed by patterning a conductor that is a copper foil simultaneously with the wiring pattern layer along four sides of the first insulating substrate 101, and has 11 front-side pads on each side. However, the number is not limited to 11.

In addition to one input pad 103a, the other input pad 104a, the bias pad 109a, the output pad 110a, the bias pad 111a, the bias pad 112a, and the GND pad 113a, the plurality of front-side pads include an input pad 121a, an output pad 122a, bias pads 123aa to 123ia, and bias pads 124aa to 124ca, which are electrically connected to the corresponding pads of the second substrate 200 via the third substrate 300, and a ground pad 125a other than them.

Each front-side pad is selected from the plurality of front-side pads depending on the line of the first wiring pattern layer.

Each of the plurality of front-side pads is electrically connected to a corresponding one of the plurality of back-side pads formed on the back surface of the first insulating substrate 101 facing each other via the via VIA.

Each of the plurality of front-side pads is electrically and physically connected to a corresponding one of the plurality of back-side pads of the third substrate 300 by a conductive connection member 50 such as a solder ball as partially illustrated in FIG. 1. Hereinafter, the connection member 50 will be described as a solder ball 50.

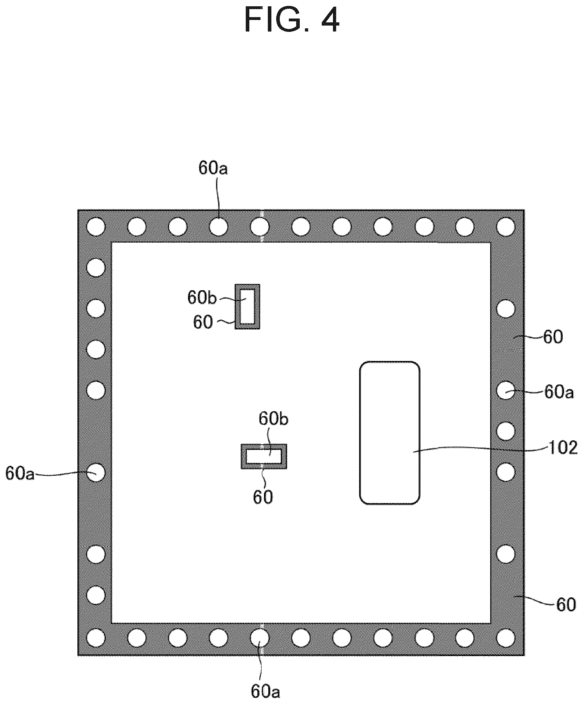

A resist film 60 is formed on the front surface of the first insulating substrate 101, and as illustrated in FIG. 4, has a circular opening 60a for exposing front surfaces of the input pad 121a, the output pad 122a, the bias pads 123aa to 123ia, the bias pads 124aa to 124ca, and the ground pad 125a corresponding to the second substrate 200, and for mounting solder balls 50, and a rectangular opening 60b for mounting a chip component (not illustrated).

The resist film 60 covers front surfaces of the one input pad 103a, the other input pad 104a, the bias pad 109a, the output pad 110a, the bias pad 111a, and the bias pad 112a, and protects these front-side pads.

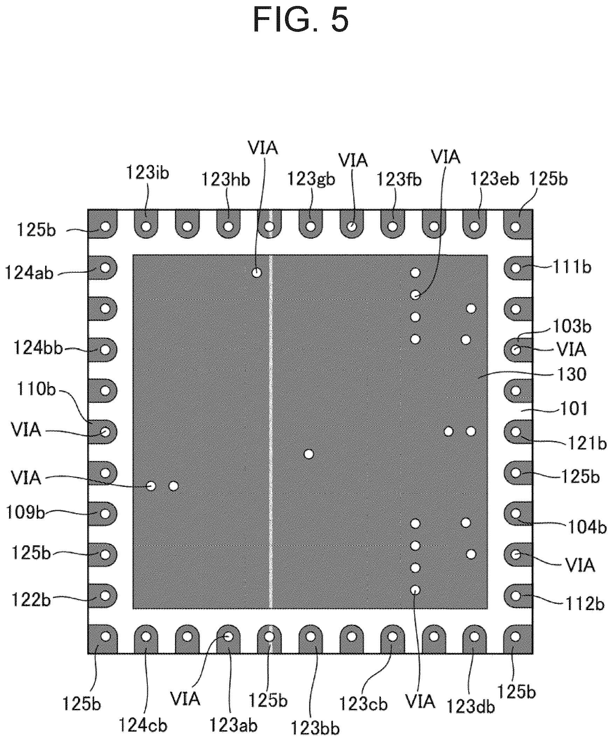

As illustrated in FIG. 5, the first base portion 130 formed on the back surface of the first insulating substrate 101 is formed by patterning a conductor which is a thick copper foil having a thickness of 100 um or more, in this example, 200 um in the central portion excluding the periphery.

The first base portion 130 is electrically connected to each of the plurality of GND lines 113 formed on the front surface of the first insulating substrate 101 by a via VIA indicated by marks ∘ in the drawing in the first base portion 130.

In the first base portion 130, the first semiconductor element 10 is mounted and fixed on the exposed surface of the first insulating substrate 101 located in the first opening 102 via the first heat sink 10A.

Since the first base portion 130 is a conductor which is a thick copper foil, heat diffusibility is good, and heat dissipation is excellent with respect to heat generated by the first semiconductor element 10.

The first base portion 130 is placed and fixed on a ground layer formed on a front surface of a mounting substrate (not illustrated) by soldering or the like, and is grounded by the ground layer of the mounting substrate.

The plurality of back-side pads formed on the back surface of the first insulating substrate 101 is formed by patterning a conductor that is a thick copper foil simultaneously with the first base portion 130 along the four sides of the first insulating substrate 101.

Each of the plurality of back-side pads is arranged to face each of the plurality of front-side pads formed on the front surface, and is electrically connected to each of the plurality of front-side pads via a via VIA penetrating the first insulating substrate 101.

In addition to one input pad 103b, the other input pad 104b, an output-side bias pad 109b, an output pad 110b, one input-side bias pad 111b, the other input-side bias pad 112b, and a GND pad 113b, the plurality of back-side pads include an input pad 121b, an output pad 122b, bias pads 123ab to 123ib, and bias pads 124ab to 124cb, which correspond to the second substrate 200, and the ground pad 125b other than them.

Each back-side pad is electrically connected to a corresponding wiring layer formed on the front surface of the mounting substrate (not illustrated) by soldering or the like.

Since the wiring pattern layer is surrounded by a plurality of ground pads 125a on the front side, a plurality of ground pads 125b on the back side, and vias VIA connecting the ground pads 125a and 125b, a structure resistant to intrusion of noise from the outside is obtained.

Note that, in FIG. 1, the plurality of back-side pads is not denoted by individual reference numerals, but is denoted by collective reference numeral 131 for convenience of description.

The second semiconductor element 20 is a semiconductor element in which an amount of heat generated during operation is smaller than an amount of heat generated during operation of the first semiconductor element 10.

The second semiconductor element 20 is a semiconductor element having a power supply control function.

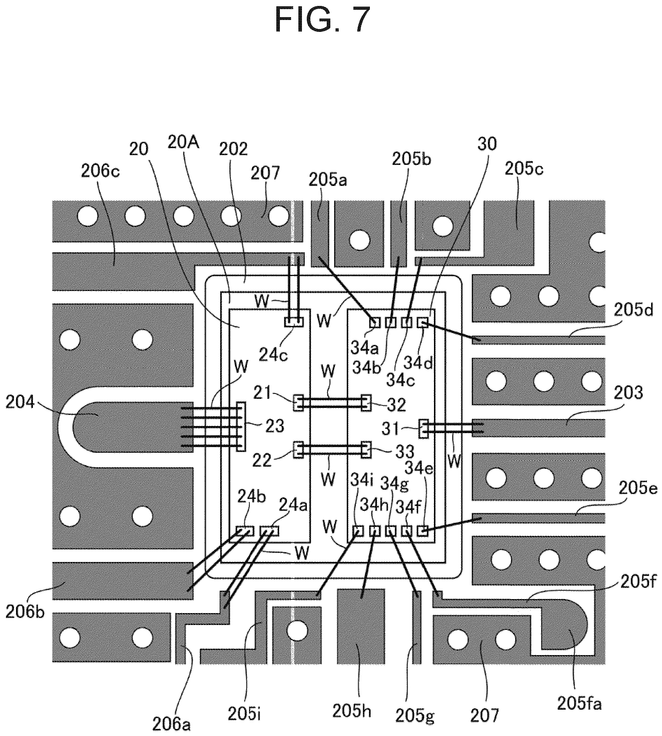

As illustrated in FIG. 7, the second semiconductor element 20 is a semiconductor chip having two input terminals 21 and 22, an output terminal 23, and three bias terminals 24a to 24c on the front surface of the semiconductor substrate.

Each of the terminals 21 to 23 and 24a to 24c is a pad formed on the front surface of the semiconductor substrate.

The third semiconductor element 30 is a semiconductor element in which an amount of heat generated during operation is smaller than an amount of heat generated during operation of the first semiconductor element 10.

The third semiconductor element 30 is a semiconductor element having a driver amplification function.

As illustrated in FIG. 7, the third semiconductor element 30 is a semiconductor chip having an input terminal 31, two output terminals 32 and 33, and nine bias terminals 34a to 34i on the front surface of the semiconductor substrate.

Each of the terminals 31 to 33 and 34a to 34i is a pad formed on the front surface of the semiconductor substrate.

The two output terminals 32 and 33 of the third semiconductor element 30 are respectively connected to the two input terminals 21 and 22 of the second semiconductor element 20 by wire bonding using wires W such as gold wires.

As illustrated in FIG. 1, the second substrate 200 includes a second insulating substrate 201 constituted by a single-layer insulating base material, a second wiring pattern layer and a plurality of second front-side pads formed on the front surface of the second insulating substrate 201, and a second base portion 230 constituted by thick copper and formed on the back surface of the second insulating substrate 201, and a second opening 202 reaching the front surface of the second base portion 230 from the front surface is formed in the second insulating substrate 201.

The second semiconductor element 20 is mounted on the second opening 202 with a second heat sink 20A interposed therebetween.

The back surface of the second semiconductor element 20 is placed and fixed on the second base portion 230 with the second heat sink 20A interposed therebetween, and the heat generated by the second semiconductor element 20 is dissipated via the second heat sink 20A and the second base portion 230.

The third semiconductor element 30 is mounted on the second opening 202 with the second heat sink 20A interposed therebetween.

The back surface of the third semiconductor element 30 is placed and fixed on the second base portion 230 with the second heat sink 20A interposed therebetween, and the heat generated by the third semiconductor element 30 is dissipated via the second heat sink 20A and the second base portion 230.

The second insulating substrate 201 is the same insulating substrate as the first insulating substrate 101.

The thickness of the second insulating substrate 201 is the same as the thickness of the first insulating substrate 101, and is a thickness up to a manufacturing limit for forming the second opening 202.

The second wiring pattern layer is constituted by the same material and has the same thickness as the first wiring pattern layer.

The second wiring pattern layer is formed by patterning a conductor that is a copper foil having a thickness of, for example, 18 um or 35 um, and includes a transmission line that transmits a signal, a power supply line that supplies power (current) from a power supply, a bias line that supplies a bias potential, and a GND line set to a ground potential.

The second wiring pattern layer constitutes a part of a high frequency package or a high frequency module incorporating a high frequency circuit, by the second semiconductor element 20, the third semiconductor element 30, and the chip component 40 (only a part thereof is illustrated) such as a chip capacitor mounted by being electrically connected to a line constituting the second wiring pattern.

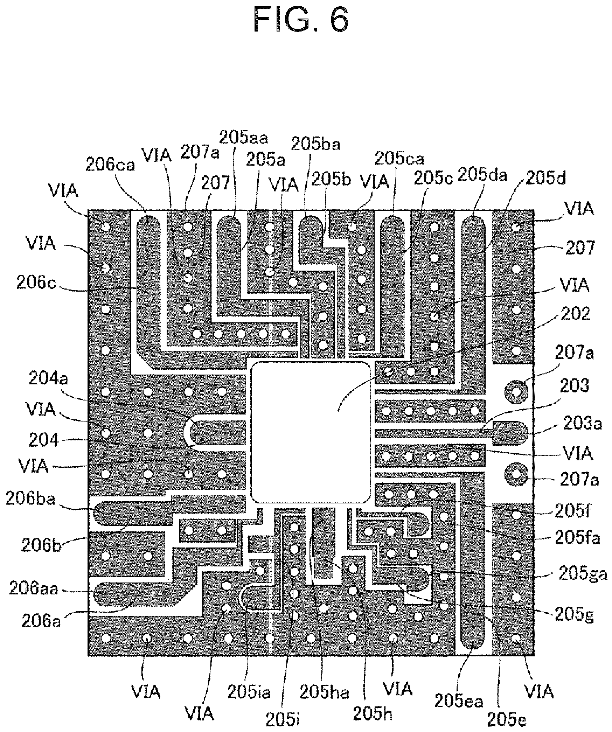

As illustrated in FIGS. 6 and 7, the second wiring pattern layer includes an input line 203, an output line 204, nine bias lines 205a to 205i on the input side, three bias lines 206a to 206c on the output side, and a plurality of GND lines 207.

The input line 203 is connected to the input terminal 31 of the third semiconductor element 30 by wire bonding using a wire W such as a gold wire.

The number of wires W is illustrated in units of two in FIG. 7, but may be one or three or more.

"The input line 203" is a collective term that refers to a line extending from a position to which the input terminal 31 of the third semiconductor element 30 is connected, to an input pad 203a.

The output line 204 is connected to the output terminal 23 of the second semiconductor element 20 by wire bonding using a wire W such as a gold wire.

"The output line 204" is a collective term that refers to a line extending from a position to which the output terminal 23 of the second semiconductor element 20 is connected, to an output pad 204a.

The bias lines 205a to 205i on the input side are respectively connected to the corresponding bias terminals 34a to 34i of the third semiconductor element 30 by wire bonding with the wires W.

Each of "the bias lines 205a to 205i" is a collective term that refers to a line extending from a position to which a corresponding one of the bias terminals 34a to 34i of the third semiconductor element 30is connected, to a corresponding one of bias pads 205aa to 205ia.

The bias lines 206a to 206c on the output side are respectively connected to the corresponding bias terminals 24a to 24c of the second semiconductor element 20 by wire bonding with the wires W.

Each of "the bias lines 206a to 206c" is a collective term that refers to a line extending from a position to which a corresponding one of the bias terminals 24a to 24c of the second semiconductor element 20 is connected, to a corresponding one of bias pads 206aa to 206ca.

Each of the input line 203, the output line 204, the bias lines 205a to 205i on the input side, and the bias lines 206a to 206c on the output side is patterned to such an extent that they are not coupled to each other, and has a pattern satisfying a required size, for example, a bent line pattern.

As illustrated in FIGS. 6 and 7, each of the plurality of GND lines 207 is arranged between adjacent transmission lines to prevent interference between signals or the like between the adjacent transmission lines.

Each of the plurality of GND lines 207 is electrically connected to the second base portion 230 formed on the back surface of the second insulating substrate 201 by a via VIA indicated by marks ∘ in FIG. 6 in the GND line 207.

Note that, among the plurality of GND lines 207, in the GND line 207 extending to the side of the second insulating substrate 201 and having a line width larger than the diameter of the pad, the position of the GND line 207 connected to the via VIA located on the side of the second insulating substrate 201 also serves as a GND pad 207A.

In the present example, the plurality of front-side pads formed on the front surface of the second insulating substrate 201 includes 11 pads on each side formed by patterning a conductor that is a copper foil simultaneously with the wiring pattern layer along four sides of the second insulating substrate 201, the output pad 204a, and bias pads 205fa to 205ia. However, the number of pads on each side is not limited to 11.

The plurality of front-side pads arranged on the four sides of the second insulating substrate 201 includes the input pad 203a, bias pads 205aa to 205ea on the input side, bias pads 206aa to 206ac on the output side, and a ground pad 207a other than these.

Each front-side pad is selected from the plurality of front-side pads depending on the line of the second wiring pattern layer.

Each of the ground pads 207a is electrically connected to the second base portion 230 formed on the back surface of the second insulating substrate 201 via the via VIA penetrating the second insulating substrate 201.

Each of the plurality of front-side pads is electrically and physically connected to a corresponding one of the plurality of front-side pads of the third substrate 300 by a conductive connection member 70 such as a solder ball as partially illustrated in FIG. 1. Hereinafter, the connection member 70 will be described as a solder ball 70.

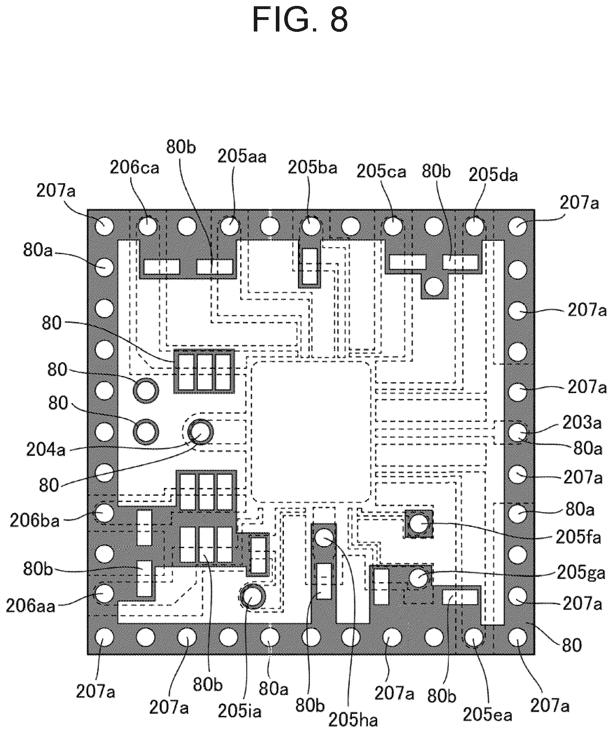

A resist film 80 is formed on the front surface of the second insulating substrate 201, exposes the front surfaces of all of the plurality of front-side pads formed on the front surface of the second insulating substrate 201, and has a circular opening 80a for mounting the solder balls 70 and a rectangular opening 80b for mounting a chip component (not illustrated), as illustrated in FIG. 8.

The second base portion 230 formed on the back surface of the second insulating substrate 201 is constituted by the same material and has the same thickness as the first base portion 130 formed on the back surface of the first insulating substrate 101.

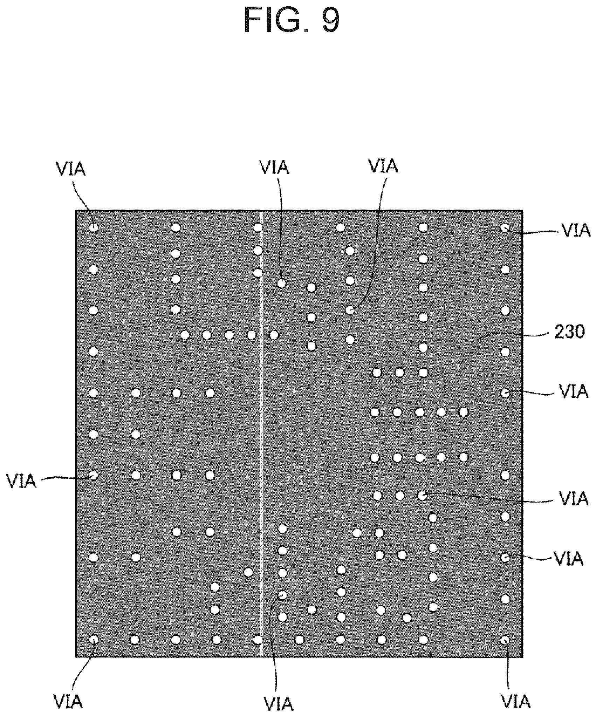

As illustrated in FIG. 9, the second base portion 230 is formed by patterning a conductor which is a thick copper foil having a thickness of 100 um or more, in this example, 200 um on the entire back surface of the second insulating substrate 201.

The second base portion 230 is electrically connected to each of the plurality of GND lines 207 and the GND pads 207A formed on the front surface of the second insulating substrate 201 by a via VIA indicated by marks o in the drawing in the second base portion 230.

In the second base portion 230, the second semiconductor element 20 and the third semiconductor element 30 are mounted and fixed on an exposed surface of the second insulating substrate 201 located in the second opening 202 with the second heat sink 20A interposed therebetween.

Since the second base portion 230 is a conductor which is a thick copper foil, heat diffusibility is good, and heat dissipation is excellent with respect to heat generated by the second semiconductor element 20 and the third semiconductor element 30.

The first semiconductor element 10, the first wiring pattern layer formed on the front surface of the first insulating substrate 101, the chip component 40 (only a part thereof is illustrated) such as a chip capacitor electrically connected to a line constituting the first wiring pattern, the second semiconductor element 20, the third semiconductor element 30, the second wiring pattern layer formed on the front surface of the second insulating substrate 201, and the chip component 40 (only a part thereof is illustrated) such as a chip capacitor electrically connected to a line constituting the second wiring pattern constitute a part of a high frequency package or a high frequency module incorporating a high frequency circuit.

The first substrate 100 and the second substrate 200 have the same thickness as a whole, and the thicknesses and materials of constituent elements thereof are the same, that is, the first insulating substrate 101 and the second insulating substrate 201 are constituted by the same material and have the same thickness, the first wiring pattern layer and the second wiring pattern layer are constituted by the same material and have the same thickness, and the first base portion 130 and the second base portion 230 are constituted by the same material and have the same thickness.

The front surface of the first substrate 100, that is, the first wiring pattern layer, and the front surface of the second substrate 200, that is, the second wiring pattern layer are arranged to face each other.

As illustrated in FIG. 1, the third substrate 300 is an interposer substrate having a multilayer structure that is arranged between the first substrate 100 and the second substrate 200 in such a manner as to face the first substrate 100 and the second substrate 200, has a plurality of third back-side pads on the back surface, each of which is connected to each of the plurality of first front-side pads of the first substrate 100 by solder balls 50, has a plurality of third front-side pads on the front surface, each of which is connected to each of the plurality of second front-side pads of the second substrate 200 by solder balls 70, and relays electrical connection between the first substrate 100 and the second substrate 200.

The third substrate 300 is an interposer substrate having a six-layer structure in this example.

The front surface side of the third substrate 300, that is, the uppermost layer will be described as the first layer, and the back surface side, that is, the lowermost layer will be described as the sixth layer. The second to fifth layers are intermediate layers, and in particular, there are an intermediate layer in which a wiring path is formed and an intermediate layer to be a ground layer.

In order to eliminate the complexity of the description, the pattern of the front surface in the first layer of the third substrate 300, that is, the pattern of the first layer (uppermost layer) is simply abbreviated as a first-layer pattern. The second to sixth layers (lowermost layers) will also be briefly described.

The first-layer pattern to the sixth-layer pattern are formed by patterning a conductor which is a copper foil having a thickness of, for example, 18 um or 35 um.

Further, although an insulating layer is interposed between adjacent patterns, the insulating layer is generally used as an interposer substrate, and thus a detailed description thereof will be omitted.

The third substrate 300 is a relay substrate that has pads arranged in a central portion on the front surface of the second substrate 200, in this example, pads arranged to face the output pad 204a and the bias pads 205fa to 205ia in the first-layer pattern, and pads arranged to face the input pad 121a, the output pad 122a, the bias pads 123aa to 123ia, the bias pads 124aa to 124ca, and the ground pads 125a, arranged along sides on the front surface of the first substrate 100, in the sixth-layer pattern, and connects corresponding pads in the pads in the first-layer pattern and the pads in the sixth-layer pattern.

Further, in the third substrate 300, the first-layer pattern is a first pad layer that connects the output pad 204a and the bias pads 205fa to 205ia on the front surface of the second substrate 200, the second-layer pattern and the fifth-layer pattern are a first wiring layer and a second wiring layer, the third-layer pattern and the fourth-layer pattern are a first ground layer and a second ground layer, and the sixth-layer pattern is a second pad layer that connects the input pad 121a, the output pad 122a, the bias pads 123aa to 123ia, and the bias pads 124aa to 124ca on the front surface of the first substrate 100.

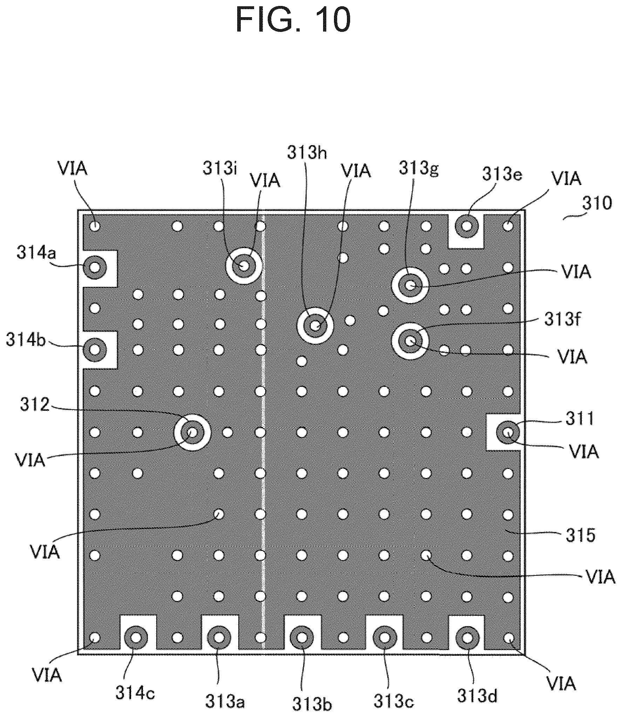

A pattern of each layer in the third substrate 300 will be described with reference to FIGS. 10 to 17.

As illustrated in FIG. 10, a first-layer pattern 310 is a pattern on the front surface of the third substrate 300, and is a pad layer connected to the front-side pad of the second substrate 200 by the solder balls 70.

The first-layer pattern 310 includes an input pad 311, an output pad 312, bias pads 313a to 313i, and bias pads 314a to 314c at positions facing the input pad 203a, the output pad 204a, the bias pads 205aa to 205ia, and the bias pads 206aa to 206ca, respectively, formed on the front surface of the second substrate 200.

Further, the first-layer pattern 310 includes a ground layer 315 which is a solid pattern electrically insulated from the input pad 311, the output pad 312, the bias pads 313a to 313i, and the bias pads 314a to 314c in a region excluding these pads.

In FIG. 10, the ground layer 315 is electrically connected to the ground layer located in the lower layer by a via VIA indicated by marks "∘" in FIG. 10 in the ground layer 315.

Note that, in the ground layer 315, a portion connected to the vias VIA located along the four sides also serves as GND pads 315a.

The input pad 311 is connected to a via VIA penetrating insulating layers of the first to fifth layers, that is, penetrates up to the sixth-layer pattern. The output pad 312 is connected to a via VIA penetrating the insulating layer of the first layer, that is, penetrates up to the second-layer pattern. The bias pads 313a to 313e are connected to vias VIA penetrating the insulating layers of the first to fifth layers, that is, penetrating through up to the sixth-layer pattern. The bias pads 313g and 313i are connected to vias VIA penetrating the insulating layer of the first layer, that is, penetrating up to the second-layer pattern. The bias pads 313f and 313h are connected to vias VIA penetrating the insulating layers of the first to fourth layers, that is, penetrating up to the fifth-layer pattern. The bias pads 314a to 314c are connected to vias VIA penetrating the insulating layer of the fifth layer, that is, penetrating up to the sixth-layer pattern.

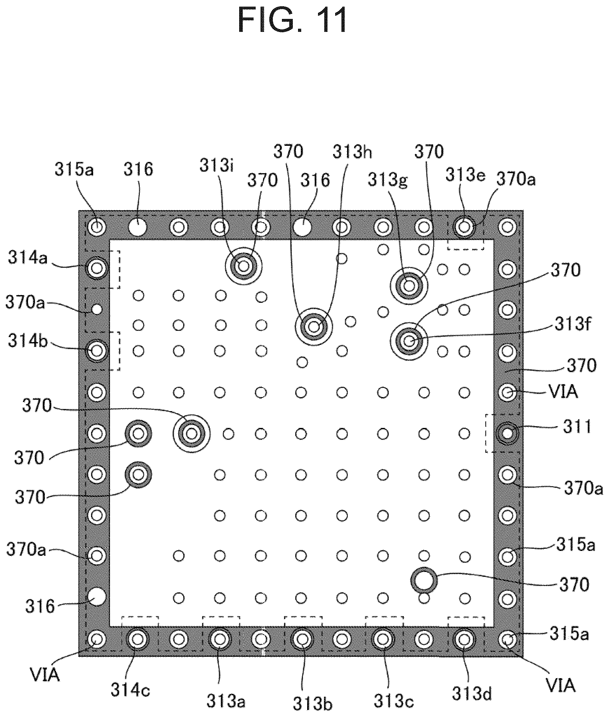

A resist film 370 is formed on a front surface of the first-layer pattern 310, and as illustrated in FIG. 11, has a circular opening 370a for exposing front surfaces of the input pad 311, the output pad 312, the bias pads 313a to 313i, the bias pads 314a to 314c, and the GND pad 315a and mounting the solder balls 70.

Note that, in FIG. 11, no via VIA exists at positions of marks o indicated by reference numeral 316, and the ground layer 315 is not electrically connected to the second-layer pattern at the position indicated by reference numeral 316.

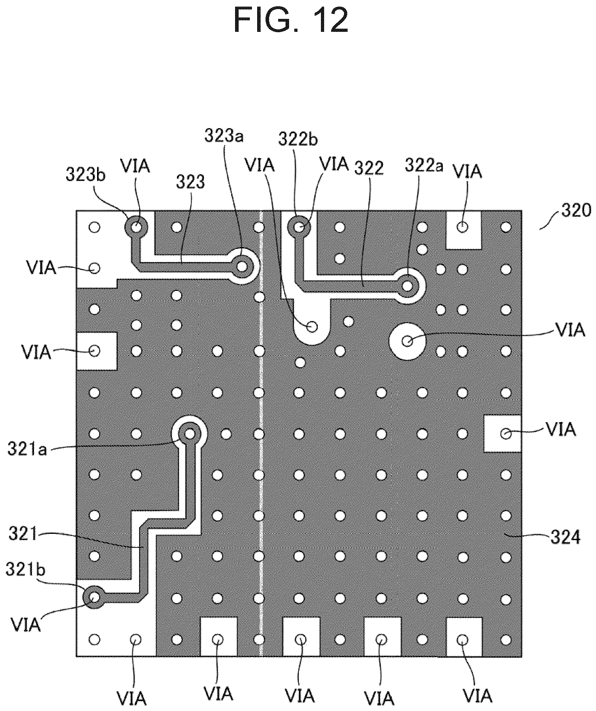

As illustrated in FIG. 12, a second-layer pattern 320 includes a first wiring path 321, a second wiring path 322, and a third wiring path 323.

Further, the second-layer pattern 320 includes a ground layer 324 which is a solid pattern electrically insulated from the vias VIA except for the vias VIA connected to the input pad 311, the bias pads 313a to 313e, 313f, and 313h, and the bias pads 314a to 314c.

The ground layer 324 is electrically connected to the ground layers located in the upper layer and the lower layer by vias VIA indicated by marks "∘" in the ground layer 324 in FIG. 12.

In the first wiring path 321, one end 321a is connected to the via VIA connected to the output pad 312 in the first-layer pattern 310, and the other end 321b is connected to the via VIA connected to an output pad 362 in the sixth-layer pattern.

In the second wiring path 322, one end 322a is connected to the via VIA connected to the bias pad 313g in the first-layer pattern 310, and the other end 322b is connected to the via VIA connected to the bias pad 363g in the sixth-layer pattern.

In the third wiring path 323, one end 323a is connected to the via VIA connected to the bias pad 313i in the first-layer pattern 310, and the other end 323b is connected to the via VIA connected to the bias pad 363i in the sixth-layer pattern.

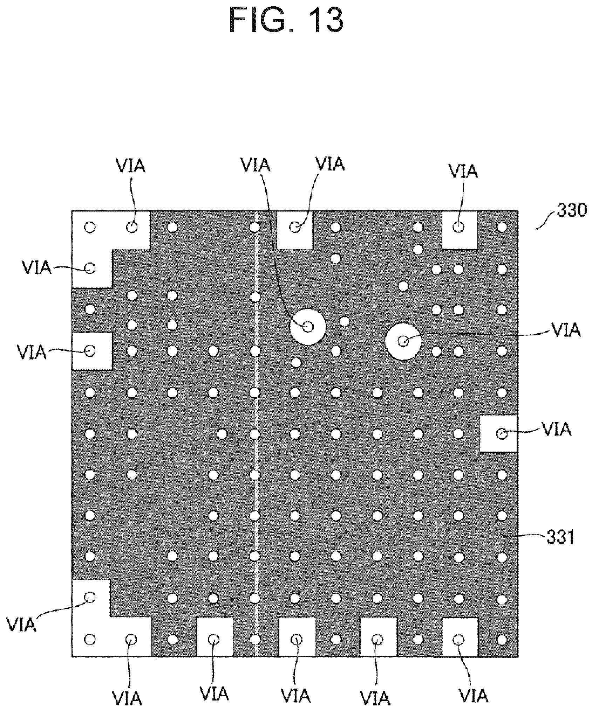

As illustrated in FIG. 13, a third-layer pattern 330 is a layer in which a region other than vias VIA excluding vias VIA set to the ground potential is set as the ground layer 331.

The ground layer 331 is electrically connected to the ground layers located in the upper layer and the lower layer by vias VIA indicated by marks "∘" in FIG. 13 in the ground layer 331.

The third-layer pattern 330 is a solid pattern electrically insulated from vias VIA that electrically connect the input pad 311, the bias pads 313a to 313e, and the bias pads 314a to 314c in the first-layer pattern 310 and the corresponding input pad 361, bias pads 363a to 363e, and bias pads 364a to 364c in a sixth-layer pattern 360, vias VIA that electrically connect the other end 321b of the first wiring path 321, the other end 322b of the second wiring path 322, and the other end 323b of the third wiring path 323 in the second-layer pattern 320 and the corresponding output pad 362 and bias pads 313g and 313i in the sixth-layer pattern 360, and a via VIA that electrically connect the bias pads 313f and 313h in the first-layer pattern 310 and one end of the corresponding fourth wiring path and one end of the fifth wiring path in the fifth-layer pattern 350.

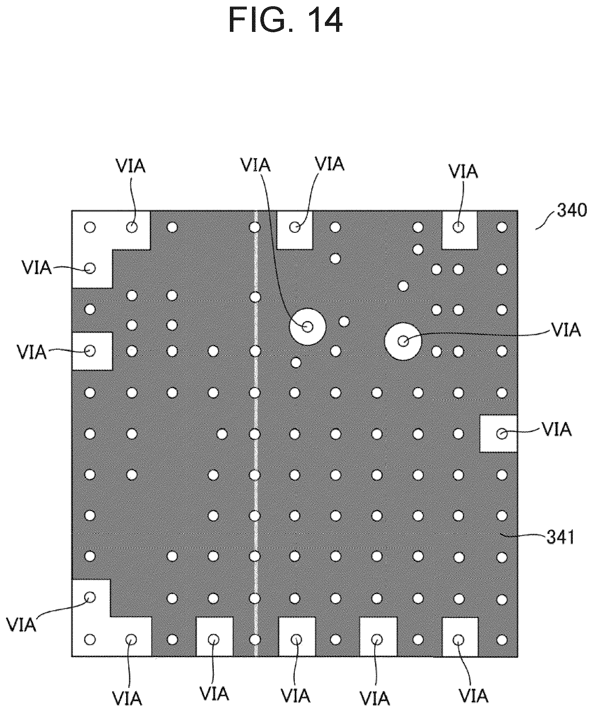

As illustrated in FIG. 14, a fourth-layer pattern 340 is a layer in which a region other than vias VIA excluding vias VIA set to the ground potential is set as the ground layer 341.

The ground layer 341 is electrically connected to the ground layers located in the upper layer and the lower layer by vias VIA indicated by marks "∘" in FIG. 14 in the ground layer 341.

The fourth-layer pattern 340 is a solid pattern having the same shape as the third-layer pattern 330.

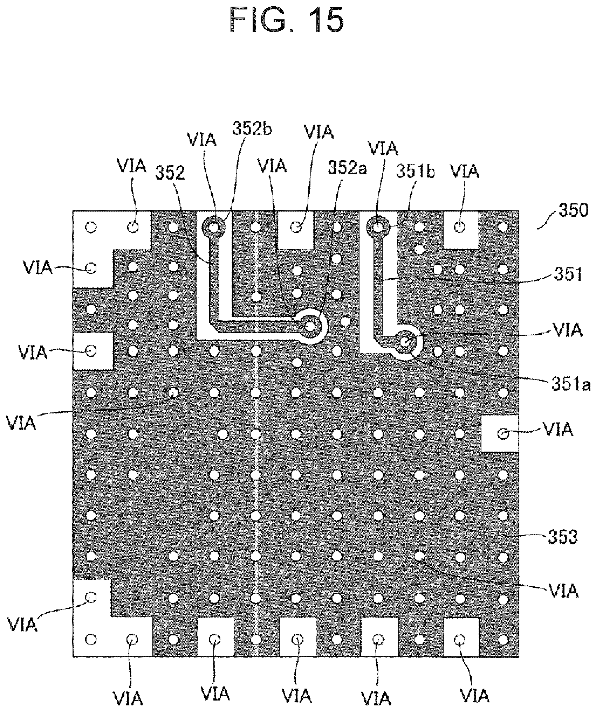

As illustrated in FIG. 15, a fifth-layer pattern 350 includes a fourth wiring path 351 and a fifth wiring path 352.

In addition, the fifth-layer pattern 350 includes a ground layer 353 that is a solid pattern electrically insulated from vias VIA except for the via VIA connected to the input pad 361, the output pad 362, the bias pads 363a to 363e, 363g, and 363i, and the bias pads 364a to 364c in the sixth-layer pattern 360.

The ground layer 353 is electrically connected to the ground layers located in the upper layer and the lower layer by vias VIA indicated by marks "∘" in FIG. 15 in the ground layer 353.

In the fourth wiring path 351, one end 351a is connected to the via VIA connected to the bias pad 313f in the first-layer pattern 310, and the other end 351b is connected to the via VIA connected to the bias pad 363f in the sixth-layer pattern.

In the fifth wiring path 352, one end 352a is connected to the via VIA connected to the bias pad 313h in the first-layer pattern 310, and the other end 352b is connected to the via VIA connected to the bias pad 363h in the sixth-layer pattern.

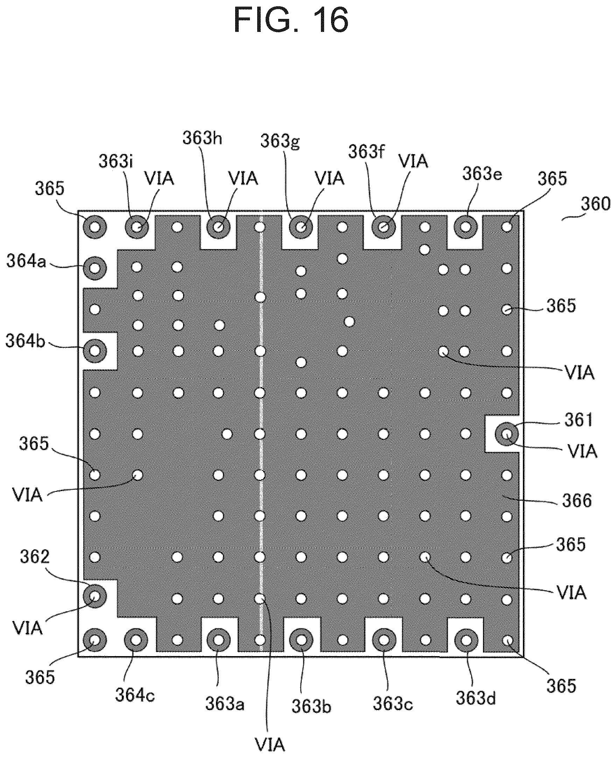

As illustrated in FIG. 16, the sixth-layer pattern 360 is a pattern on the back surface of the third substrate 300, and is a pad layer connected to the front-side pad of the first substrate 100 by the solder balls 50.

The sixth-layer pattern 360 includes the input pad 361, the output pad 362, the bias pads 363a to 363i, the bias pads 364a to 364c, and the ground pad 365 at positions facing the input pad 121a, the output pad 122a, the bias pads 123aa to 123ia, the bias pads 124aa to 124ca, and the ground pad 125a, which are formed on the front surface of the first substrate 100, respectively, along the four sides.

In addition, the sixth-layer pattern 360 includes a ground layer 366 which is a solid pattern electrically insulated from the input pad 361, the output pad 362, the bias pads 363a to 363i, and the bias pads 364a to 364c in a region excluding these pads.

In FIG. 16, the ground layer 366 is electrically connected to the ground layer located in the upper layer by a via VIA indicated by marks "∘" in FIG. 16 in the ground layer 366.

Note that, in the ground layer 366, a portion connected to the vias VIA located along the four sides also serves as the GND pad 365. However, the vias VIA do not serve as the GND pads 365 at positions facing the plurality of front-side pads in the first substrate 100.

The input pad 361 is connected to the via VIA connected to the input pad 311 in the first-layer pattern 310. The output pad 362 is connected to a via VIA connected to the other end 321b of the first wiring path 321 in the second-layer pattern 320. The bias pads 363a to 363e are connected to the vias VIA connected to the bias pads 313a to 313e in the first-layer pattern 310. The bias pad 363f is connected to the via VIA connected to the other end 351b of the fourth wiring path 351 in the fifth-layer pattern 350. The bias pad 363g is connected to the via VIA connected to the other end 322b of the second wiring path 322 in the second-layer pattern 320. The bias pad 363h is connected to the via VIA connected to the other end 352b of the fifth wiring path 352 in the fifth-layer pattern 350. The bias pad 363i is connected to the via VIA connected to the other end 323b of the third wiring path 323 in the second-layer pattern 320. The bias pads 364a to 364c are connected to the vias VIA connected to the bias pads 314a to 314c in the first-layer pattern 310.

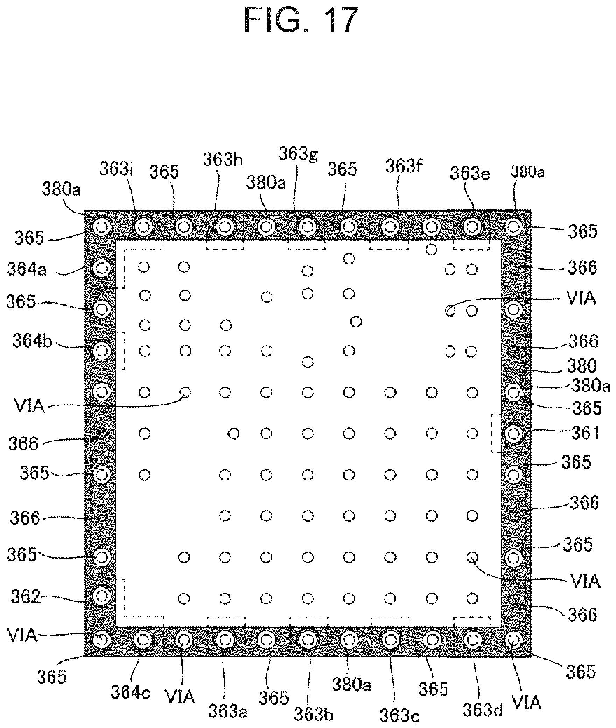

A resist film 380 is formed on the front surface of the sixth-layer pattern 360, and as illustrated in FIG. 17, has a circular opening 380a for exposing the front surfaces of the input pad 361, the output pad 362, the bias pads 363a to 363i, the bias pads 364a to 364c, and the ground pad 365 and mounting the solder ball 50.

Note that, in FIG. 17, the resist film 380 covers the front surface at positions indicated by marks "∘" denoted by reference numeral 366, that is, positions facing the one input pad 103a, the other input pad 104a, the bias pad 109a, the output pad 110a, the bias pad 111a, and the bias pad 112a in the first substrate 100.

As illustrated in FIGS. 12 and 15, the first wiring path 321 to the third wiring path 323 in the second-layer pattern 320 and the fourth wiring path 351 and the fifth wiring path 352 in the fifth-layer pattern 350 each include at least one bent portion instead of a straight line in such a manner that the first wiring path 321 to the third wiring path 323 do not structurally and electrically interfere with the fourth wiring path 351 and the fifth wiring path 352.

As described above, in the third substrate 300, since the first-layer pattern 310 and the sixth-layer pattern 360 serving as pad layers have regions other than pads excluding the ground pads as the ground layers 315 and 366, the second-layer pattern 320 and the fifth-layer pattern 350 serving as wiring layers have regions other than wiring paths and vias VIA connected to pads excluding the ground pads as the ground layers, and the third-layer pattern and the fourth-layer pattern have regions other than vias VIA connected to pads excluding the ground pads as the ground layers 331 and 341, unnecessary coupling between the first semiconductor element 10 mounted on the first substrate 100 and the second semiconductor element 20 and the third semiconductor element 30 mounted on the second substrate 200 and further unnecessary coupling between the first wiring path 321 and the third wiring path 323 in the second-layer pattern 320 and the fourth wiring path 351 and the fifth wiring path 352 in the fifth-layer pattern 350 can be suppressed, and moreover, wiring can be performed by the necessary wiring path without increasing the size of the third substrate 300 in the plane direction, and the semiconductor device itself can be downsized.

Next, assembly of the semiconductor device according to the first embodiment will be described.

It is assumed that the first semiconductor element 10 is mounted in the first opening 102 of the first substrate 100, the wire bonding is finished, the second semiconductor element 20 and the third semiconductor element 30 are mounted in the second opening 202 of the second substrate 200, and the wire bonding is finished.

In addition, it is assumed that necessary chip components are mounted on the front surface of the first substrate 100 and the front surface of the second substrate.

First, in the first substrate 100, the first base portion 130 is bonded and fixed to the ground layer formed on the front surface of the mounting substrate, and each of the plurality of back-side pads is bonded and fixed to the corresponding wiring layer and ground layer formed on the front surface of the mounting substrate by soldering, and the first substrate 100 is mounted on the mounting substrate.

Each of the plurality of front-side pads whose front surface is exposed through the opening 60a in the resist film 60 in the first substrate 100 and each of the plurality of back-side pads whose front surface is exposed through the opening 380a in the resist film 380 in the third substrate 300 face each other with corresponding pads facing each other, and the third substrate 300 is placed on the first substrate 100 with the back surface of the third substrate 300 facing the front surface of the first substrate 100 with the solder balls 50 interposed therebetween.

Each of the plurality of front-side pads whose front surface is exposed through the opening 370a in the resist film 370 in the third substrate 300 and each of the plurality of front-side pads whose front surface is exposed through the opening 80a in the resist film 80 in the second substrate 200 face each other with corresponding pads facing each other, and the second substrate 200 is placed on the third substrate 300 with the front surface of the second substrate 200 facing the front surface of the third substrate 300 with the solder balls 70 interposed therebetween.

In this manner, in a state where the third substrate 300 and the second substrate 200 are stacked on the front surface of the first substrate 100, the solder balls 50 and the solder balls 70 are heated in such a manner as to be melted. In addition, the pressure is applied from the second substrate 200 side as necessary.

When the solder balls 50 and the solder balls 70 are melted, the corresponding pads are bonded to each other, the corresponding pads are electrically connected to each other, the third substrate 300 is mounted and fixed on the first substrate 100, the second substrate 200 is mounted and fixed on the third substrate 300, and the semiconductor device is assembled.

By heat for melting the solder balls 50 and the solder balls 70, thermal expansion occurs in each of the first substrate 100, the second substrate 200, and the third substrate 300.

However, since the first substrate 100 and the second substrate 200 are arranged on the upper and lower sides, warpage of the first substrate 100, the second substrate 200, and the third substrate 300 that occurs at the time of assembly is reduced, improvement of yield as a semiconductor device and stability of performance can be compensated, and reliability as a semiconductor device is improved.

High-frequency input signals to the input terminals 11 and 12 of the first semiconductor element 10 are supplied from the mounting substrate to the input terminals 11 and 12 via the input pads 103b and 104b-the vias VIA-the input pads 103a and 104a-the input lines 103 and 104 in the first substrate 100.

The high-frequency amplified signal output from the output terminals 13 and 14 of the first semiconductor element 10 is transmitted through the first transmission line 106, the second transmission line 107, and the third transmission line 108 in the first substrate 100, and is output from the output node 105a of the output synthesis circuit 105 to the mounting substrate via the output line 110-the output pad 110a-the via VIA-the output pad 110b.

A bias current to each of the bias terminals 15 and 16 of the first semiconductor element 10 is supplied from the mounting substrate to the bias terminals 15 and 16 via the bias pads 111b and 112b-the via VIA-the bias pads 111a and 112a-the bias lines 111 and 112 in the first substrate 100.

A bias current to the output node 105a of the output synthesis circuit 105 is supplied from the mounting substrate to the output node 105a via the bias pad 109b-the via VIA-the bias pad 109a-the bias line 109 in the first substrate 100.

An input signal to each of the input terminals 31 of the third semiconductor element 30 is supplied from the mounting substrate to the input terminal 31 via the input pad 121b-the via VIA-the input pad 121-the solder ball 50 on the first substrate 100, via the input pad 361-the via VIA-the input pad 311-the solder ball 70 on the third substrate 300, and via the input pad 203a-the input line 203 on the second substrate 200.

Output signals output from the output terminals 32 and 33 of the second semiconductor element 20 are output to the mounting substrate via the output line 204-the output pad 204a-the solder ball 70 on the second substrate 200, via the output pad 312-the via VIA-the first wiring path 321-the via VIA-the output pad 362-the solder ball 50 on the third substrate 300, and via the output pad 122a-the via VIA-the output pad on the first substrate 100.

A bias current to each of the bias terminals 24a to 24c of the second semiconductor element 20 is supplied from the mounting substrate to the bias terminals 24a to 24c via the bias pads 124ab to 124cb-the via VIA-the bias pads 124aa to 124ca-the solder balls 50 on the first substrate 100, via the bias pads 364a to 364c-the via VIA-the bias pads 314a to 314c-the solder balls 70 on the third substrate 300, and via the bias pads 206aa to 206ac-the bias lines 206a to 206c on the second substrate 200.

A bias current to each of the bias terminals 34a to 34e of the third semiconductor element 30 is supplied from the mounting substrate to the bias terminals 34a to 34e via the bias pads 123ab to 123eb-the via VIA-the bias pads 123aa to 123ea-the solder balls 50 on the first substrate 100, via the bias pads 363a to 363e-the via VIA-the bias pads 313a to 313e-the solder balls 70 on the third substrate 300, and via the bias pads 205aa to 205ea-the bias lines 205a to 205e on the second substrate 200.

A bias current to the bias terminal 34f of the third semiconductor element 30 is supplied from the mounting substrate to the bias terminal 34f via a bias pad 123fb-the via VIA-a bias pad 123fa-the solder ball 50 on the first substrate 100, via the bias pad 363f-the via VIA-the fourth wiring path 351-the via VIA-the bias pad 313f-the solder ball 70 on the third substrate 300, and via the bias pad 205fa-the bias line 205f on the second substrate 200.

A bias current to the bias terminal 34g of the third semiconductor element 30 is supplied from the mounting substrate to the bias terminal 34g via a bias pad 123gb-the via VIA-a bias pad 123ga-the solder ball 50 on the first substrate 100 via the bias pad 363g-the via VIA-the second wiring path 322-the via VIA-the bias pad 313g-the solder ball 70 on the third substrate 300, and via the bias pad 205ga-the bias line 205g on the second substrate 200.

A bias current to the bias terminal 34h of the third semiconductor element 30 is supplied from the mounting substrate to the bias terminal 34g via a bias pad 123hb-the via VIA-a bias pad 123ha-the solder ball 50 on the first substrate 100, via the bias pad 363h-the via VIA-the fifth wiring path 352-the via VIA-the bias pad 313g-the solder ball 70 on the third substrate 300, and via the bias pad 205ga-the bias line 205g on the second substrate 200.

A bias current to the bias terminal 34i of the third semiconductor element 30 is supplied from the mounting substrate to the bias terminal 34g via the bias pad 123ib-the via VIA-the bias pad 123ia-the solder ball 50 on the first substrate 100, via the bias pad 363i-the via VIA-the third wiring path 323-the via VIA-the bias pad 313i-the solder ball 70 on the third substrate 300, and via the bias pad 205ia-the bias line 205i on the second substrate 200.

As described above, in the semiconductor device according to the first embodiment, the first substrate 100 and the second substrate 200 have a stacked structure in such a manner as to sandwich the third substrate 300, the first base portion 130 and the second base portion 230 constituted by thick copper are provided on the back surfaces of the first substrate 100 and the second substrate 200, the first semiconductor element 10 is placed and fixed on the front surface of the first base portion 130 via the first heat sink 10A in the first opening 102 reaching the front surface of the first base portion 130, and the second semiconductor element 20 is placed and fixed on the front surface of the first base portion 130 via the second heat sink 20A in the second opening 202 reaching the front surface of the second base portion 230, the first base portion 130 and the second base portion 230 have good diffusibility with respect to heat generated by the first semiconductor element 10 and the second semiconductor element 20, and heat dissipation as a semiconductor device is improved.

In addition, in the semiconductor device according to the first embodiment, since the first substrate 100, the second substrate 200, and the third substrate 300 are heated at the time of assembling them, expansion by heat occurs in each of the first substrate 100, the second substrate 200, and the third substrate 300, but since the stacked structure in which the first substrate 100 and the second substrate 200 of the same form are arranged vertically is employed, warpage of the first substrate 100, the second substrate 200, and the third substrate 300 is reduced, the improvement of the yield and the stability of the performance as a semiconductor device can be compensated, and the reliability as a semiconductor device is improved.

In addition, since the semiconductor device according to the first embodiment includes, in the first wiring pattern layer in the first substrate 100, the output synthesis circuit 105 having the first transmission line 106 and the second transmission line 107 connected in series between the output node 105a and the one output terminal 13 of the first semiconductor element 10, and the third transmission line 108 connected between the output node 105a and the other output terminal 14 of the first semiconductor element 10, it is possible to achieve ultra-wide band characteristics and miniaturize the semiconductor device without using a matching circuit.

Moreover, since the output synthesis circuit 105 can be formed as a wiring pattern on the front surface of the first substrate 100, the influence of unnecessary parasitic components can be reduced, and ultra-wideband characteristics can be achieved.

Furthermore, in the semiconductor device according to the first embodiment, since the third substrate 300 has the ground layer 315 and the ground layer 366 which are solid patterns on the front surface and the back surface, respectively, unnecessary coupling between the first semiconductor element 10 and the second semiconductor element 20 and the third semiconductor element 30 can be suppressed, wiring can be performed by a necessary wiring path without increasing the size of the third substrate 300 in the plane direction, and the semiconductor device itself can be miniaturized.

In the semiconductor device according to the first embodiment, since the first substrate 100 and the second substrate 200 are formed into a stacked package as a stacked structure in such a manner as to sandwich the third substrate 300, reliability as a circuit is improved.

Note that, although the first semiconductor element 10 is mounted on the first substrate 100 in the semiconductor device according to the first embodiment, another semiconductor element may be further mounted.

In addition, although the second semiconductor element 20 and the third semiconductor element 30 are mounted on the second substrate 200, other semiconductor elements may be further mounted.

Further, the third semiconductor element 30 or another semiconductor element may be mounted on the third substrate 300.

On the third substrate 300, some of the transmission lines in the output synthesis circuit 105 formed on the front surface of the first substrate 100 may be formed.

Although the wiring path in the third substrate 300 is a wiring path for both the second semiconductor element 20 and the third semiconductor element 30, the wiring path may be a wiring path for either one of the second semiconductor element 20 and the third semiconductor element 30.

### Second Embodiment

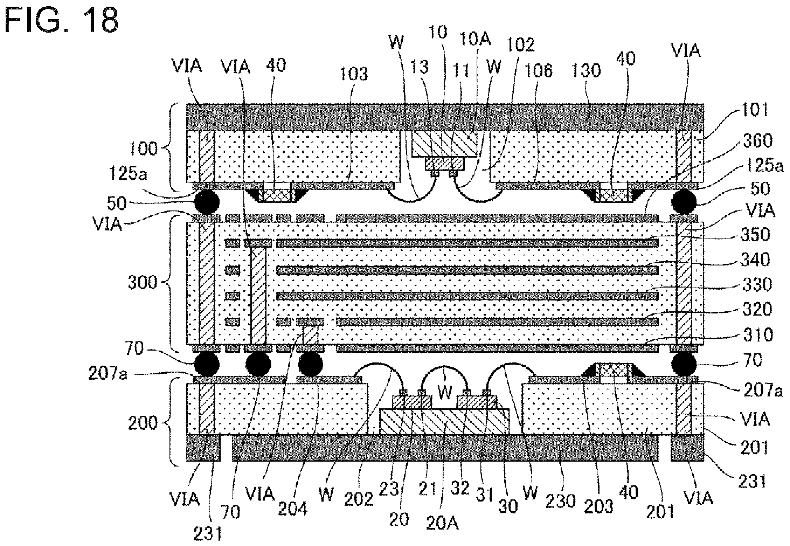

A semiconductor device according to a second embodiment will be described with reference to FIG. 18.

The semiconductor device according to the second embodiment is different from the semiconductor device according to the first embodiment in that the semiconductor device according to the first embodiment has a structure in which the first substrate 100 is mounted and fixed on the mounting substrate and the third substrate 300 and the second substrate 200 are stacked in this order, whereas the semiconductor device according to the second embodiment has a structure in which the second substrate 200 is mounted and fixed on the mounting substrate and the third substrate 300 and the first substrate 100 are stacked in this order.

The basic configurations of first substrate 100, second substrate 200, and third substrate 300 in the semiconductor device according to the second embodiment are the same as those of first substrate 100, second substrate 200, and third substrate 300 in the semiconductor device according to the first embodiment, and thus differences will be mainly described.

Note that, in FIG. 18, the same reference numerals as those attached in FIG. 1 denote the same or corresponding parts.

The first substrate 100 does not include the plurality of back-side pads 131 in the first embodiment, and includes a first base portion 130 formed by patterning a conductor that is a thick copper foil having a thickness of 100 um or more, in this example, 200 um on the entire back surface of the first insulating substrate 101.

The first base portion 130 is connected to a ground pad 125a formed on the front surface of the first insulating substrate 101 via a via VIA.

By forming the first base portion 130 on the entire back surface of the first insulating substrate 101, a higher heat dissipation effect can be obtained for the first semiconductor element 10 generating a large amount of heat.

The first substrate 100 is not provided with the vias VIA illustrated in the first embodiment for the front-side pads other than the ground pad 125a.

The other configurations of first substrate 100 are the same as those of the first substrate 100 in the first embodiment.

The second substrate 200 has a plurality of back-side pads 231 formed by patterning a conductor that is a thick copper foil simultaneously with the second base portion 230 along four sides of the back surface of the second insulating substrate 201.

The plurality of back-side pads 231 is pads corresponding to the plurality of back-side pads 131 on first substrate 100 in the first embodiment.

That is, the plurality of back-side pads 231 corresponding to the one input pad 103b, the other input pad 104b, the output-side bias pad 109b, the output pad 110b, the one input-side bias pad 111b, the other input-side bias pad 112b, the GND pad 113b, the input pad 121b, the output pad 122b, the bias pads 123ab to 123ib, the bias pads 124ab to 124cb, and the ground pad 125a of pads other than them, which are the plurality of back-side pads 131 in the first substrate 100, are formed in the same arrangement along four sides of the back surface of the second insulating substrate 201.

Further, in the second substrate 200, a plurality of front-side pads is formed along four sides of the front surface of the second insulating substrate 201 in such a manner as to correspond to the plurality of back-side pads 231, and the plurality of back-side pads 231 and the plurality of front-side pads are electrically connected to each other by the vias VIA.

On the second substrate 200, among the front-side pads formed on the front surface of the second insulating substrate 201, the input pad 203a, the bias pads 205aa to 205ea on the input side, and the bias pads 206aa to 206ac on the output side are covered with the resist film 80, the front surfaces of the plurality of other front-side pads is exposed through the circular opening 80a of the resist film 80, and the solder ball 70 is mounted.

Other configurations of the second substrate 200 are the same as those of the second substrate 200 in the first embodiment.

As illustrated in FIG. 18, the third substrate 300 is an interposer substrate having a multilayer structure that is arranged between the second substrate 200 and the first substrate 100 in such a manner as to face the first substrate 100 and the second substrate 200, has a plurality of third front-side pads on the front surface, each of which is connected to a plurality of second front-side pads of the second substrate 200 by solder balls 70, and has a plurality of third back-side pads on the back surface, each of which is connected to a plurality of first front-side pads of the first substrate 100 by solder balls 50.

The third substrate 300 is a substrate that relays electrical connection between a front-side pad arranged in the central portion of the second substrate 200, in this example, the output pad 204a and each of the bias pads 205fa to 205ia, and a front-side pad arranged at the side portion of the second substrate 200, in this example, a front-side pad (hereinafter referred to as output pads 222 and bias pads 223f to 223i for distinction) corresponding to the output pad 122b and each of the bias pads 123fb to 123ib of the first substrate 100.

The third substrate 300 is an interposer substrate having a six-layer structure in this example.

The front surface side of the third substrate 300, that is, the lowermost layer will be described as the first layer, and the back surface side, that is, the uppermost layer will be described as the sixth layer.

In the following description, each layer pattern is similar to each layer pattern in the first embodiment, and thus will be described without using the drawings. Note that reference numerals are given for distinction.

The first-layer pattern 310 is a pattern on the front surface of the third substrate 300, and is a pad layer connected to the front-side pad of the second substrate 200 by the solder balls 70.

The first-layer pattern 310 includes pads corresponding to the front-side pads formed on the front surface of the second substrate 200 and the ground layer 315 that is a solid pattern, similarly to the first-layer pattern 310 in the first embodiment.

The second-layer pattern 320 includes the first wiring path 321, the second wiring path 322, the third wiring path 323, and the ground layer 324 that is a solid pattern, similarly to the second-layer pattern 320 in the first embodiment.

In the first wiring path 321, one end is connected to the via VIA connected to the output pad 312 arranged in the central portion of the first-layer pattern 310, and the other end is connected to the via VIA connected to the output pad 362 arranged at the side portion of the sixth-layer pattern.

In the second wiring path 322, one end is connected to the via VIA connected to the bias pad 313g arranged in the central portion of the first-layer pattern 310, and the other end is connected to the via VIA connected to the bias pad 363g arranged at the side portion of the sixth-layer pattern.

In the third wiring path 323, one end is connected to the via VIA connected to the bias pad 313i arranged in the central portion of the first-layer pattern 310, and the other end is connected to the via VIA connected to the bias pad 363i in the sixth-layer pattern arranged at the side portion.

The third-layer pattern 330 and the fourth-layer pattern 340 are the same as the third-layer pattern 330 and the fourth-layer pattern 340 in the first embodiment, and are the ground layer 331 and the ground layer 341 which are solid patterns, respectively.

The fifth-layer pattern 350 includes the fourth wiring path 351, the fifth wiring path 352, and the ground layer 353 that is a solid pattern, similarly to the fifth-layer pattern 350 in the first embodiment.

In the fourth wiring path 351, one end is connected to the via VIA connected to the bias pad 313f arranged in the central portion of the first-layer pattern 310, and the other end is connected to the via VIA connected to the bias pad 363f arranged at the side portion of the sixth-layer pattern.

In the fifth wiring path 352, one end is connected to the via VIA connected to the bias pad 313h arranged in the central portion of the first-layer pattern 310, and the other end is connected to the via VIA connected to the bias pad 363h arranged at the side portion of the sixth-layer pattern.

The sixth-layer pattern 360 is a pattern on the back surface of the third substrate 300, and is a pad layer connected to the front-side pad of the first substrate 100 by the solder balls 50.

Similarly to the sixth-layer pattern 360 in the first embodiment, the sixth-layer pattern 360 includes pads corresponding to the front-side pads formed on the front surface of the first substrate 100 and a ground layer 366 that is a solid pattern.

Since the semiconductor device according to the second embodiment is configured as described above, each of the input terminals 11 and 12, the output terminals 13 and 14, and the bias terminals 15 and 16 of the first semiconductor element 10 is connected to the first wiring pattern layer formed on the front surface of the first substrate 100 by a wire W, and is connected to the mounting substrate via the pad-the solder ball 50 formed on the front surface of the first substrate 100, via the pad of the sixth-layer pattern 360-the via VIA-the pad of the first-layer pattern 310-the solder ball 70 on the third substrate 300, and via the front-side pad-the via VIA-the back-side pad on the second substrate 200.

Each of the bias terminals 24a to 24c of the second semiconductor element 20 and the input terminal 31 and the bias terminals 34a to 34i of the third semiconductor element 30 is connected to the second wiring pattern layer formed on the front surface of the second substrate 200 by the wire W, and is connected to the mounting substrate via the front-side pad-the via VIA-the back-side pad formed on the side portion of the front surface of the second substrate 200.

Each of the output terminal 23 of the second semiconductor element 20 and the bias terminals 34g and 34i of the third semiconductor element 30 is connected to the second wiring pattern layer formed on the front surface of the second substrate 200 by the wires W, and is connected to the mounting substrate via the front-side pad formed in the central portion on the front surface of the second substrate 200-the solder ball 70, via the pad formed in the central portion of the first-layer pattern-the via VIA-the first wiring path 321, the second wiring path 322, and the third wiring path 323 on the third substrate 300-the via VIA-the pad formed at the side portion of the first-layer pattern-the solder ball 70, and via the back-side pad formed at the side portion on the front surface of the second substrate 200.

Each of the bias terminals 34f and 34h of the third semiconductor element 30 is connected to the second wiring pattern layer formed on the front surface of the second substrate 200 by the wire W, and is connected to the mounting substrate via the front-side pad formed in the central portion on the front surface of the second substrate 200-the solder ball 70, via the pad formed in the central portion of the first-layer pattern-the via VIA-the fourth wiring path 351 and the fifth wiring path 352 on the third substrate 300-the via VIA-the pad formed at the side portion the first-layer pattern-the pad-solder ball 70, and via the back-side pad formed at the side portion on the front surface of the second substrate 200.

As described above, the semiconductor device according to the second embodiment has effects similar to those of the semiconductor device according to the first embodiment, and the front surface of the first base portion 130 of the first substrate 100 is in direct contact with air, so that heat dissipation is good, and heat generated by the first semiconductor element 10 having a large amount of heat generation generated during operation is efficiently dissipated, so that heat dissipation as a semiconductor device is improved.

In addition, since the heat dissipation as a semiconductor device is improved, the size can be further reduced.

### Third Embodiment

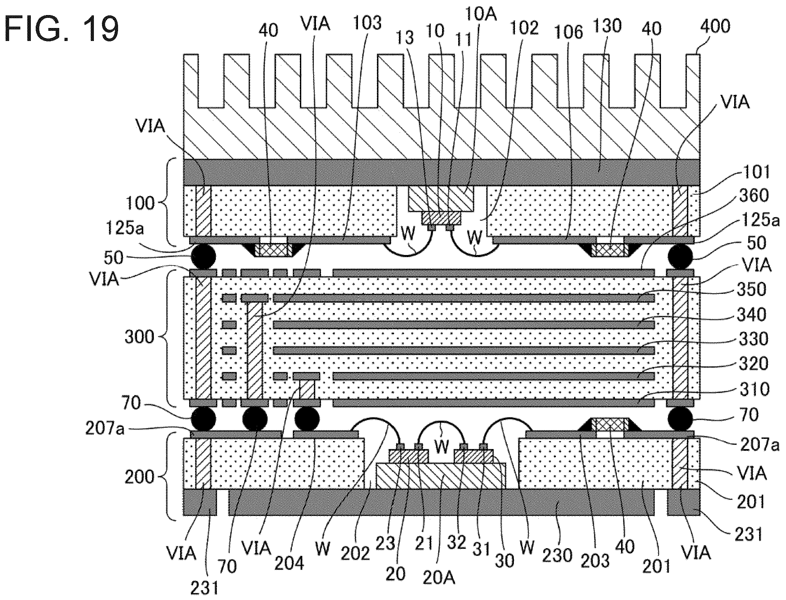

A semiconductor device according to a third embodiment will be described with reference to FIG. 19.

The semiconductor device according to the third embodiment is different from the semiconductor device according to the second embodiment in that a heat radiator 400 mounted on the back surface of the first base portion 130 of the first substrate 100 is provided, and the other points are the same.

As illustrated in FIG. 19, the semiconductor device according to the third embodiment includes a heat radiator 400 which is a heat radiating fin fixed to the entire back surface of the first base portion 130 by solder or the like.

Note that the size of the heat radiator 400 in the plane may be larger than the size of the plane of the back surface of the first base portion 130.

Note that, in FIG. 19, the same reference numerals as those attached to FIGS. 1, 18, and the like denote the same or corresponding parts.

The semiconductor device according to the third embodiment has effects similar to those of the semiconductor device according to the second embodiment, and also efficiently dissipates heat generated by the first semiconductor element 10 having a large amount of heat generation generated during operation by the heat radiator 400, thereby improving heat dissipation as a semiconductor device.

In addition, since the heat dissipation as a semiconductor device is improved, the size can be further reduced.

### Fourth Embodiment

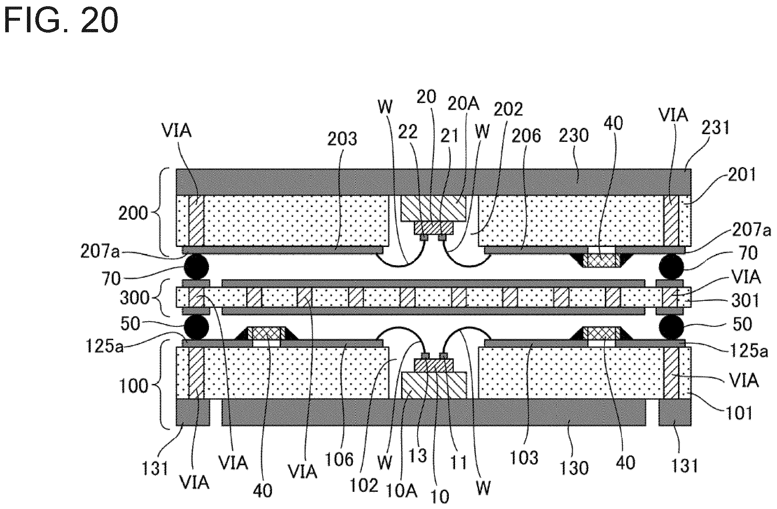

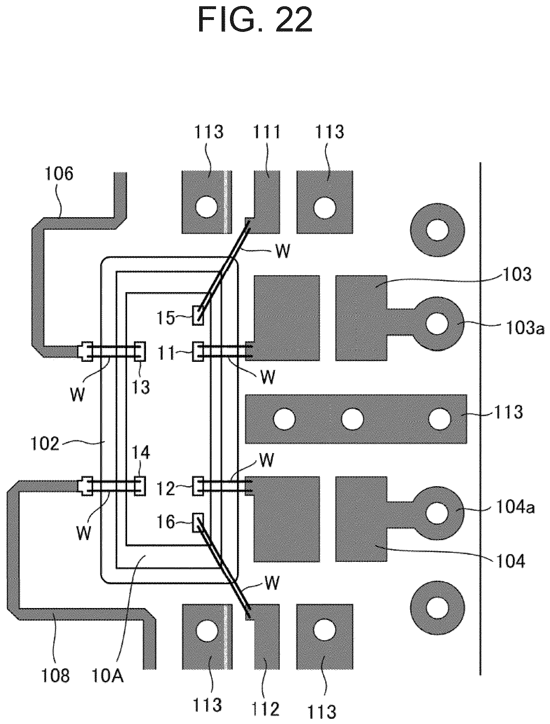

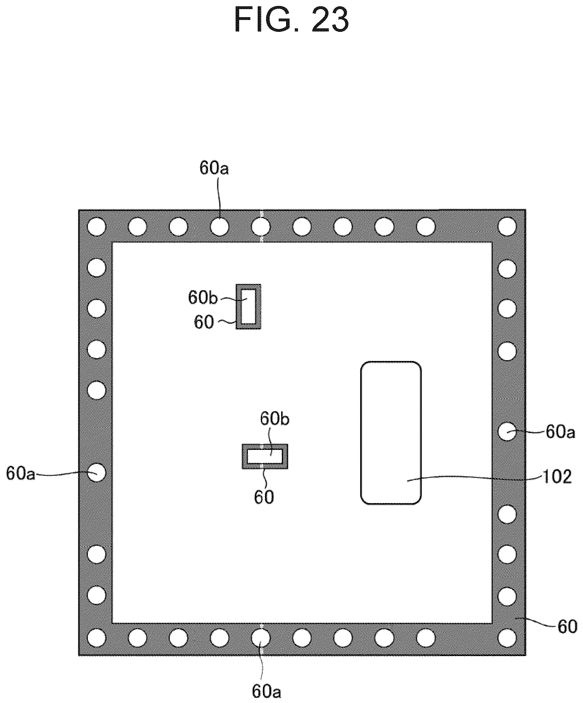

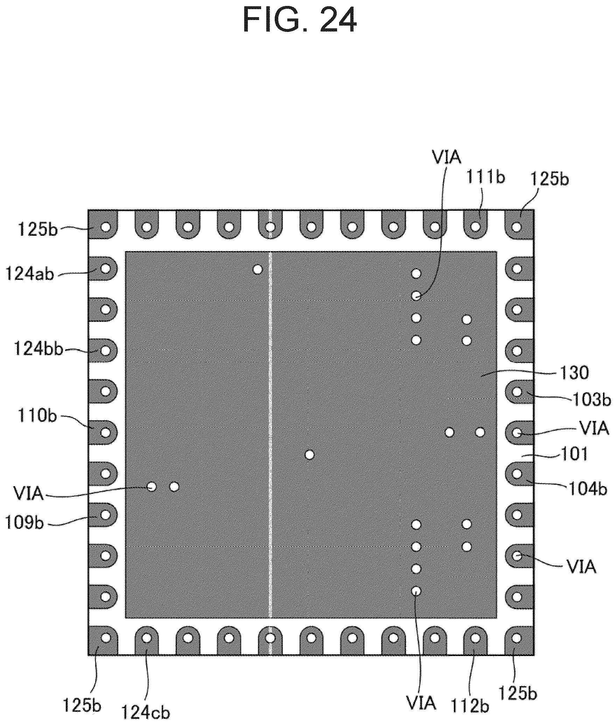

A semiconductor device according to a fourth embodiment will be described with reference to FIGS. 20 to 32.

The semiconductor device according to the fourth embodiment is different in that, while the second semiconductor element 20 and the third semiconductor element 30 are mounted on the second substrate 200 in the semiconductor device according to the first embodiment, only the second semiconductor element 20 that is a semiconductor element having a power supply control function is mounted, and accordingly, the third substrate 300 is an interposer substrate that is a single-layer substrate, and the other points are the same.

Note that, in FIGS. 20 to 32, the same reference numerals as those attached in FIGS. 1 to 17 denote the same or corresponding parts.

The semiconductor device according to the fourth embodiment is a stacked semiconductor device in which the semiconductor element 10 having a high output amplification function and the semiconductor element 20 having a power supply control function are mounted, the semiconductor element being used in a high frequency device such as communication.

In particular, the semiconductor device according to the fourth embodiment is a semiconductor device having high reliability and high manufacturability while achieving ultra-wideband characteristics that can substantially cover the entire region of the Sub-6 band.

As illustrated in FIG. 20, the semiconductor device according to the fourth embodiment includes the first semiconductor element 10, the second semiconductor element 20, the first substrate 100, the second substrate 200, and the third substrate 300.

The first semiconductor element 10 and the second semiconductor element 20 are the same as the first semiconductor element 10 and the second semiconductor element 20 in the first embodiment.

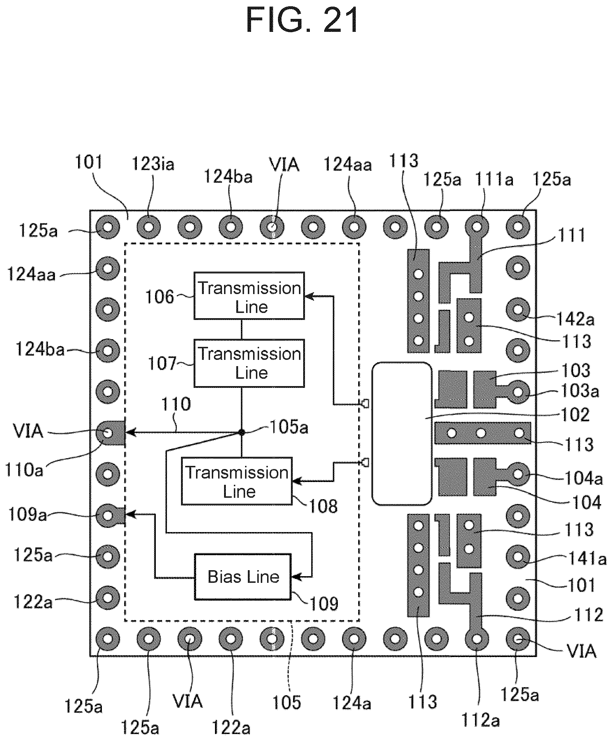

As illustrated in FIGS. 21 to 24, the basic configuration of the first substrate 100 is the same as that of the first substrate 100 according to the first embodiment.

That is, since the third semiconductor element 30 is not mounted on the second substrate 200, in the first substrate 100, the input pads 121a and the bias pads 123aa to 123ia, which are front-side pads, and the input pads 121b and the bias pads 123ab to 123ib, which are back-side pads, of the first substrate 100 with respect to the third semiconductor element in the first embodiment are set as the ground pads 125a and 125b, and one input pads 141a and 141b and the other input pads 142a and 142b, which are front-side pads and back-side pads, with respect to one input terminal 21 and the other input terminal 22 of the second semiconductor element 20 are included.

The configuration of the first substrate 100 other than those described above is the same as the configuration of first substrate 100 in the first embodiment.

Since the pad for the third semiconductor element is not provided, the first wiring pattern in the first wiring pattern layer formed on the front surface of the first insulating substrate 101 is slightly different in pattern from the first wiring pattern in the first wiring pattern layer formed on the front surface of the first substrate 100 in the first embodiment, but the functions are exactly the same.

As illustrated in FIG. 20, the second substrate 200 includes the second insulating substrate 201 constituted by the single-layer insulating base material, the second wiring pattern layer and the plurality of second front-side pads formed on the front surface of the second insulating substrate 201, and the second base portion 230 constituted by thick copper and formed on the back surface of the second insulating substrate 201, and the second opening 202 reaching the front surface of the second base portion 230 from the front surface is formed in the second insulating substrate 201.

The second insulating substrate 201 is the same insulating substrate as the first insulating substrate 101.

The thickness of the second insulating substrate 201 is the same as the thickness of the first insulating substrate 101, and is a thickness up to a manufacturing limit for forming the second opening 202.

The second wiring pattern layer is constituted by the same material and has the same thickness as the first wiring pattern layer.

In the second substrate 200, the second semiconductor element 20 is mounted in the second opening 202 via the second heat sink 20A.

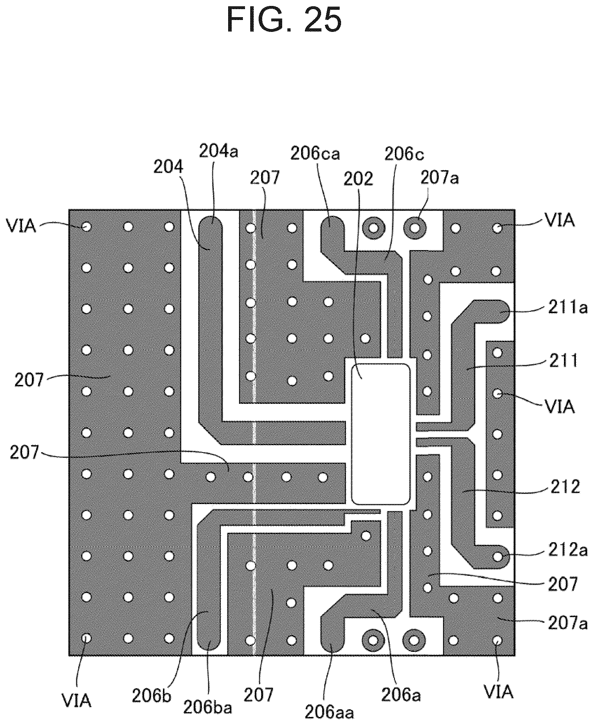

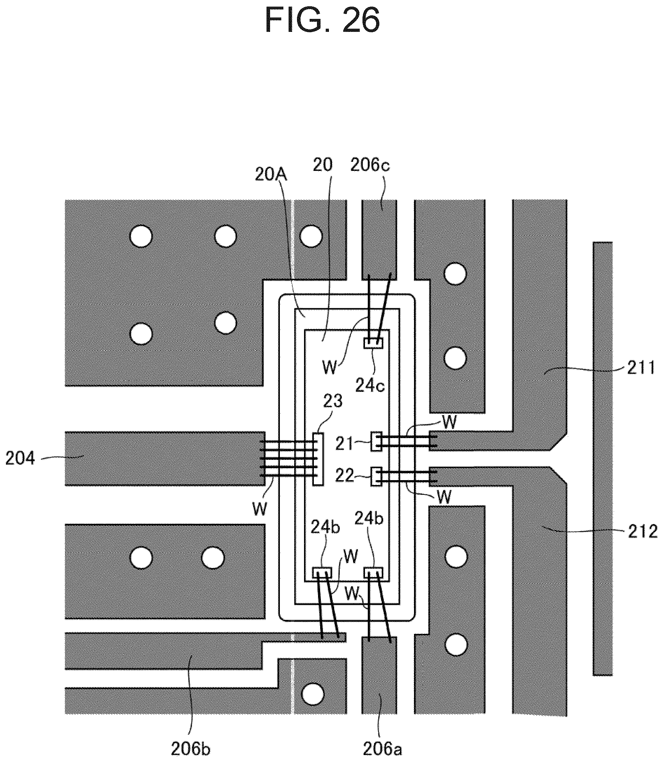

As illustrated in FIGS. 25 and 26, the second wiring pattern layer formed on the front surface of the second insulating substrate 201 in the second substrate 200 includes two input lines 211 and 212, an output line 204, three bias lines 206a to 206c, and a plurality of GND lines 207.

One input line 211 is connected to one input terminal 21 of the second semiconductor element 20 by wire bonding with a wire W such as a gold wire.

The other input line 212 is connected to the other input terminal 22 of the second semiconductor element 20 by wire bonding with a wire W such as a gold wire.

The number of wires W is illustrated in units of two in FIG. 26, but may be one or three or more.

Each of "the input lines 211 and 212" is a collective term that refers to a line extending from a position to which a corresponding one of the input terminals 21 and 22 of the second semiconductor element 20 is connected, to a corresponding one of input pads 211a and 212a.

The output line 204 is connected to the output terminal 23 of the second semiconductor element 20 by wire bonding using a wire W such as a gold wire.

"The output line 204" is a collective term that refers to a line extending from a position to which the output terminal 23 of the second semiconductor element 20 is connected, to the output pad 204a.

The bias lines 206a to 206c are connected to the corresponding bias terminals 24a to 24c of the second semiconductor element 20 by wire bonding with wires W.

Each of "the bias lines 206a to 206c" is a collective term that refers to a line extending from a position to which a corresponding one of the bias terminals 24a to 24c of the second semiconductor element 20 is connected, to a corresponding one of the bias pads 206aa to 206ca.

Each of the input lines 211 and 212, the output line 204, and the bias lines 206a to 206c is patterned to such an extent that they are not coupled to each other, and has a pattern satisfying a required size, for example, a bent line pattern.

As illustrated in FIGS. 25 and 26, each of the plurality of GND lines 207 is arranged between adjacent transmission lines to prevent interference between signals or the like between the adjacent transmission lines.

Each of the plurality of GND lines 207 is electrically connected to the second base portion 230 formed on the back surface of the second insulating substrate 201 by a via VIA indicated by marks o in FIG. 25 in the GND line 207.

Note that, among the plurality of GND lines 207, in the GND line 207 extending to the side of the second insulating substrate 201 and having a line width larger than the diameter of the pad, the position of the GND line 207 connected to the via VIA located on the side of the second insulating substrate 201 also serves as the GND pad 207a.

In the present example, the plurality of front-side pads formed on the front surface of the second insulating substrate 201 includes 11 pads on each side formed by patterning a conductor that is a copper foil simultaneously with the wiring pattern layer along the four sides of the second insulating substrate 201. However, the number of pads on each side is not limited to 11.

The plurality of front-side pads arranged on the four sides of the second insulating substrate 201 includes the input pads 211a and 212a, the output pad 204a, the bias pads 206aa to 206ac, and the other ground pads 207a.

Each front-side pad is selected from the plurality of front-side pads depending on the line of the second wiring pattern.

Each of the ground pads 207a is electrically connected to the second base portion 230 formed on the back surface of the second insulating substrate 201 via the via VIA penetrating the second insulating substrate 201.

Each of the plurality of front-side pads is electrically and physically connected to each of the plurality of front-side pads of the corresponding third substrate 300 by a conductive connection member 70 such as a solder ball as partially illustrated in FIG. 20. Hereinafter, the connection member 70 will be described as a solder ball 70.

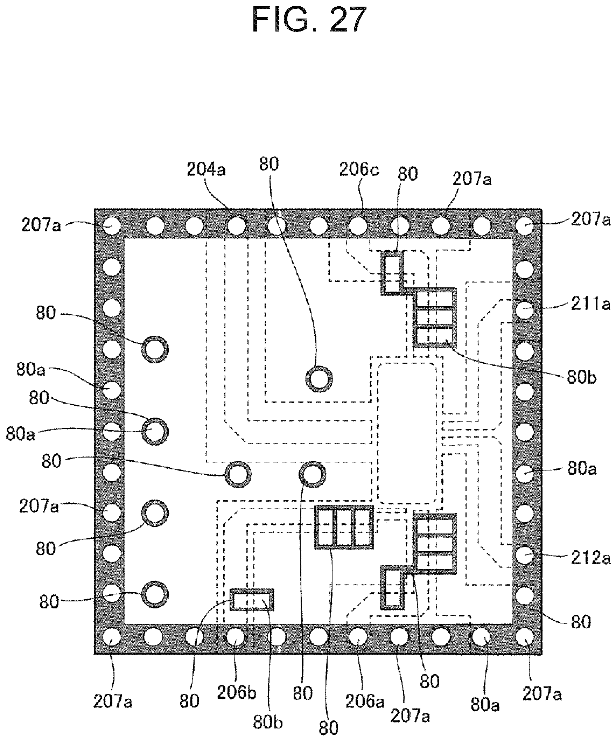

The resist film 80 is formed on the front surface of the second insulating substrate 201, exposes the front surfaces of all of the plurality of front-side pads formed on the front surface of the second insulating substrate 201, and has a circular opening 80a for mounting the solder balls 70 and a rectangular opening 80b for mounting a chip component (not illustrated), as illustrated in FIG. 27.

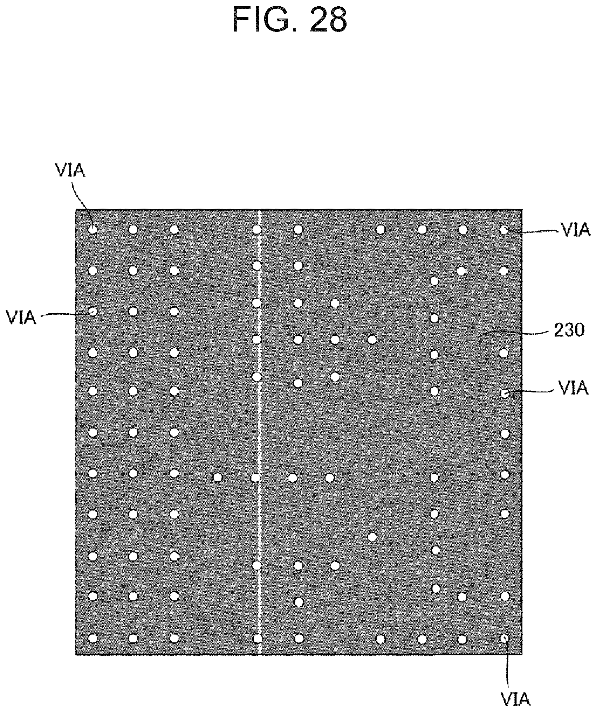

As illustrated in FIG. 28, the second base portion 230 formed on the back surface of the second insulating substrate 201 is electrically connected to each of the plurality of GND lines 207 and the GND pads 207a formed on the front surface of the second insulating substrate 201 by a via VIA indicated by marks ∘ in the drawing in the second base portion 230.

The first substrate 100 and the second substrate 200 have the same thickness as a whole, and the thicknesses and materials of constituent elements thereof are the same, that is, the first insulating substrate 101 and the second insulating substrate 201 are constituted by the same material and have the same thickness, the first wiring pattern layer and the second wiring pattern layer are constituted by the same material and have the same thickness, and the first base portion 130 and the second base portion 230 are constituted by the same material and have the same thickness.

The front surface of the first substrate 100, that is, the first wiring pattern layer, and the front surface of the second substrate 200, that is, the second wiring pattern layer are arranged to face each other.

As illustrated in FIG. 20, the third substrate 300 is an interposer substrate having a single-layer structure that is arranged between the first substrate 100 and the second substrate 200 in such a manner as to face the first substrate 100 and the second substrate 200, has a plurality of third back-side pads on the back surface, each of which is connected to each of the plurality of first front-side pads of the first substrate 100 by a solder ball 50, has a plurality of third front-side pads on the front surface, each of which is connected to each of the plurality of second front-side pads of the second substrate 200 by a solder ball 70, and relays electrical connection between the first substrate 100 and the second substrate 200.

That is, the third substrate 300 includes a single-layer insulating substrate 301, a plurality of third front-side pads 317, 318, 312, and 313a to 313c and a ground layer 315 formed on the front surface of the insulating substrate 301, and a plurality of third back-side pads 367, 368, 362, and 363a to 363c and a ground layer 365 formed on the back surface of the insulating substrate 301.

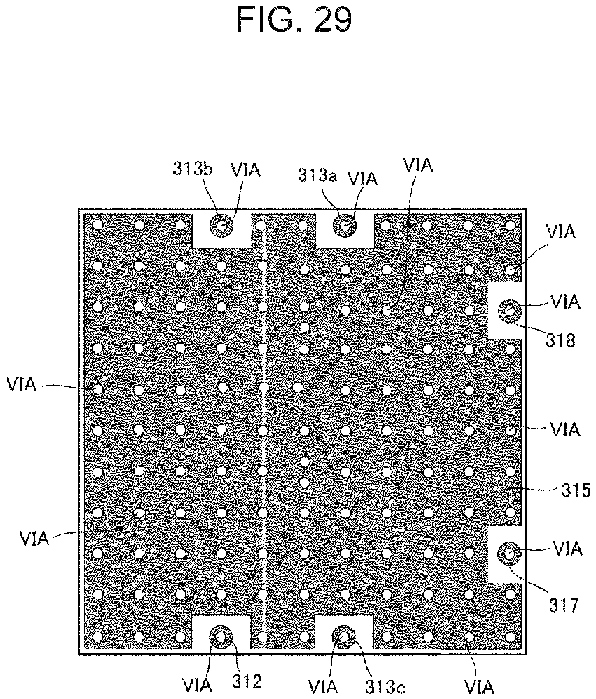

As illustrated in FIG. 29, the plurality of third front-side pads 317, 318, 312, and 313a to 313c is arranged at the side portion of the insulating substrate 301 at positions facing the input pads 211a and 212a, the output pad 204a, and the bias pads 206aa to 206ca of the second substrate 200, and are connected by the solder balls 70.

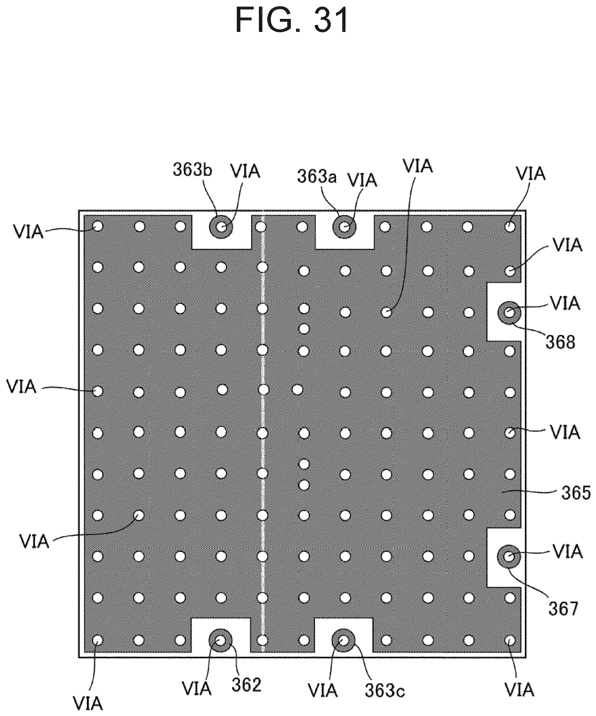

As illustrated in FIG. 31, the plurality of third back-side pads 367, 368, 362, and 363a to 363c is arranged at the side portion of the insulating substrate 301 at positions facing the plurality of third front-side pads 317, 318, 312, and 313a to 313c, respectively.

The plurality of third front-side pads 317, 318, 312, and 313a to 313c and the plurality of third back-side pads 367, 368, 362, and 363a to 363c facing each other are connected via the vias VIA.

Each of the plurality of third back-side pads 367, 368, 362, and 363a to 363c is connected to one input pad 141a, the other input pad 142a, the output pad 122a, and the bias pads 124aa to 124ca on the opposing first substrate 100 by the solder balls 50.

As illustrated in FIG. 29, the ground layer 315 formed on the front surface of the insulating substrate 301 is a solid pattern electrically insulated from the third front-side pads 317, 318, 312, and 313a to 313c in a region excluding these pads.

The ground layer 315 is electrically connected to the ground layer 315 formed on the front surface of the insulating substrate 301 by a via VIA indicated by marks ∘ in FIG. 29 in the ground layer 325.

Note that, in the ground layer 315, a portion connected to the vias VIA located along the four sides of the insulating substrate 301 also serves as the GND pad 315a.

As illustrated in FIG. 31, the ground layer 365 formed on the back surface of the insulating substrate 301 is a solid pattern electrically insulated from the third back-side pads 367, 368, 362, and 363a to 363c in a region excluding these pads.

Note that, in the ground layer 365, a portion connected to the vias VIA located along the four sides of the insulating substrate 301 also serves as the GND pad 365a.

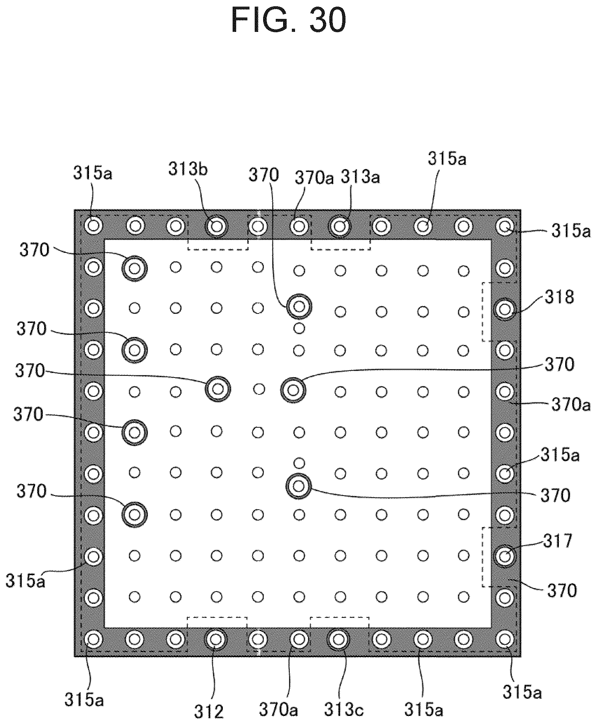

The resist film 370 is formed on the front surface of the insulating substrate 301, and as illustrated in FIG. 30, has a circular opening 370a for exposing the front surfaces of the input pads 317 and 318, the output pad 312, the bias pads 313a to 313c, and the GND pad 315a and mounting the solder balls 70.

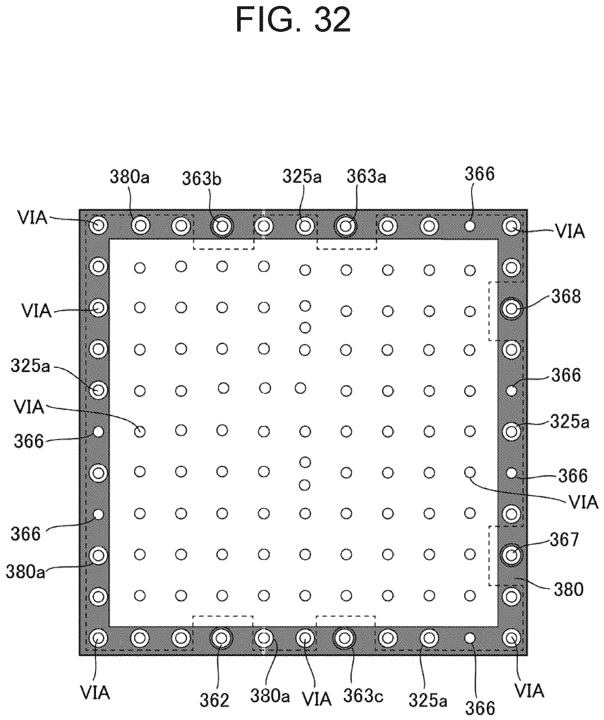

The resist film 380 is formed on the back surface of the insulating substrate 301, and as illustrated in FIG. 32, has a circular opening 380a for exposing the front surfaces of the input pads 367 and 368, the output pad 362, the bias pads 363a to 364c, and the GND pad 365a, and mounting the solder ball 50.

Note that, in FIG. 32, the resist film 380 covers the front surface at positions indicated by marks "∘" denoted by collective reference numeral 366, that is, positions facing the one input pad 103a, the other input pad 104a, the bias pad 109a, the output pad 110a, the bias pad 111a, and the bias pad 112a in the first substrate 100.

As described above, in the third substrate 300, since the regions other than the pads excluding the ground pads on both the front surface and the back surface of the insulating substrate 301 are the ground layers 315 and 365, unnecessary coupling between the first semiconductor element 10 mounted on the first substrate 100 and the second semiconductor element 20 mounted on the second substrate 200 can be suppressed, and the semiconductor device itself can be downsized.

As described above, similarly to the semiconductor device according to the first embodiment, the semiconductor device according to the fourth embodiment has good diffusibility with respect to heat generated by the first semiconductor element 10 and the second semiconductor element 20 by the first base portion 130 and the second base portion 230, improves heat dissipation as a semiconductor device, reduces warpage of the first substrate 100, the second substrate 200, and the third substrate 300, can compensate for improvement in yield and stability in performance as a semiconductor device, and improves reliability as a semiconductor device.

In addition, in the semiconductor device according to the fourth embodiment, similarly to the semiconductor device according to the first embodiment, since the output synthesis circuit 105 can be formed as a wiring pattern on the front surface of the first substrate 100, the influence of unnecessary parasitic components can be reduced, and ultra-wideband characteristics can be achieved.

Further, in the semiconductor device according to the fourth embodiment, similarly to the semiconductor device according to the first embodiment, since the third substrate 300 has the ground layer 315 and the ground layer 365 which are solid patterns on the front surface and the back surface of the insulating substrate 301, respectively, unnecessary coupling between the first semiconductor element 10, the second semiconductor element 20, and the third semiconductor element 30 can be suppressed, and the semiconductor device itself can be miniaturized.

In the semiconductor device according to the fourth embodiment, since the first substrate 100 and the second substrate 200 are formed into a stacked package as a stacked structure in such a manner as to sandwich the third substrate 300, reliability as a circuit is improved.

### INDUSTRIAL APPLICABILITY

The semiconductor device according to the present disclosure is suitable for a semiconductor device on which a semiconductor element that is a high-power amplifier is mounted in the field of high frequency devices such as communication.

### REFERENCE SIGNS LIST

10: First semiconductor element, 10A: First heat sink, 20: Second semiconductor element, 20A: Second heat sink, 30: Third semiconductor element, 40: Chip component, 50 and 70: Connection member, 100: First substrate, 101: First insulating substrate, 102: First opening, 103 and 104: Input line, 105: Output synthesis circuit, 106: First transmission line, 107: Second transmission line, 108: Third transmission line, 109: Bias line on output side, 110: Output line, 111 and 112: Bias line on input side, 113: Ground line, 130: First base portion, 200: Second substrate, 201: Second insulating substrate, 202: Second opening, 203: Input line, 204: Output line, 205a to 205i: Bias line on input side, 206a to 206c: Bias line on output side, 207: Ground line, 230: Second base portion, 300: Third substrate, 310 to 360: First-layer pattern to sixth-layer pattern, 301: Insulating substrate, 400: Heat radiator

## Claims

1. A semiconductor device comprising:
a first substrate (100) including a first insulating substrate (101), a first wiring pattern layer and a plurality of first front-side pads formed on a front surface of the first insulating substrate (101), and a first base portion (130) constituted by copper having a thickness of 100 µm or more and formed on a back surface of the first insulating substrate (101), wherein a first opening (102) reaching a front surface of the first base portion (130) from the front surface is formed in the first insulating substrate (101);
a first semiconductor element (10) mounted and fixed on the front surface of the first base portion (130) of the first substrate (100) via a first heat sink (10A) in the first opening (102) of the first substrate (100), and electrically connected to a line implemented in the first wiring pattern layer of the first substrate (100), the line being connected to one of the plurality of first front-side pads;
a second substrate (200) including a second insulating substrate (201), a second wiring pattern layer and a plurality of second front-side pads formed on a front surface of the second insulating substrate (201), and a second base portion (230) constituted by copper having a thickness of 100 µm or more and formed on a back surface of the second insulating substrate (201), wherein a second opening (202) reaching a front surface of the second base portion (230) from the front surface is formed in the second insulating substrate (201);
a second semiconductor element (20) mounted and fixed on the front surface of the second base portion (230) of the second substrate (200) via a second heat sink (20A) in the second opening (202) of the second substrate (200), and electrically connected to a line implemented in the second wiring pattern layer of the second substrate (200), the line being connected to one of the plurality of second front-side pads; and
a third substrate (300), which relays electrical connection between the first substrate (100) and the second substrate (200), arranged between the first substrate (100) and the second substrate (200) in such a manner as to face the first substrate (100) and the second substrate (200), the third substrate (300) including a plurality of third back-side pads on a back surface thereof, each of the third back-side pads being connected to a corresponding one of the plurality of first front-side pads of the first substrate (100) by a connection member (50), and a plurality of third front-side pads on a front surface thereof, each of the third front-side pads being connected to a corresponding one of the plurality of second front-side pads of the second substrate (200) by a connection member (70); wherein the third substrate (300) has a ground layer that is a solid pattern on each of the front surface and the back surface.

2. The semiconductor device according to claim 1, wherein
the first insulating substrate (101) in the first substrate (100) and the second insulating substrate (201) in the second substrate (200) are constituted by a same material and have a same thickness,
the first wiring pattern layer in the first substrate (100) and the second wiring pattern layer in the second substrate (200) are constituted by a same material and have a same thickness, and
the first base portion (130) in the first substrate (100) and the second base portion (230) in the second substrate (200) are constituted by a same material and have a same thickness.

3. The semiconductor device according to any one of claims 1 to 2, wherein
the first semiconductor element (10) is a semiconductor element having a high output amplification function,
the second semiconductor element (20) is a semiconductor element having a power supply control function, and
the third substrate (300) is a substrate that relays electrical connection between the first substrate (100) and the second substrate (200).

4. The semiconductor device according to claim 3, further comprising a third semiconductor element (30) having a driver amplification function, the third semiconductor element (30) being mounted and fixed on the front surface of the second base portion (230) of the second substrate (200) via the second heat sink (20A) in the second opening (202) of the second substrate (200), and electrically connected to the line constituting the second wiring pattern layer of the second substrate (200).

5. The semiconductor device according to any one of claims 1 to 2, wherein
the first semiconductor element (10) is a semiconductor element having a high output amplification function,
the second semiconductor element (20) is a semiconductor element having a power supply control function,
at least one of the plurality of second front-side pads formed on the front surface of the second insulating substrate (201) is arranged in a central portion of the front surface of the second insulating substrate (201), and
the third substrate (300) is a substrate that relays electrical connection between a front-side pad arranged in a central portion of the second substrate (200) and a front-side pad arranged at a side portion of the second substrate (200).

6. The semiconductor device according to claim 5, further comprising a heat radiator (400) mounted on a back surface of the first base portion (130) in the first substrate (100).

7. The semiconductor device according to any one of claims 1 to 2, wherein
the third substrate (300) has an intermediate layer pattern between the solid pattern on the front surface and the solid pattern on the back surface and
the intermediate layer pattern includes a wiring path for electrically connecting a third front-side pad of the third front-side pads and the third back-side pad of the third back-side pads corresponding to the third front-side pad.

8. The semiconductor device according to claim 7, wherein
the intermediate layer pattern includes a first intermediate layer pattern and a second intermediate layer pattern that are arranged to face each other, and
a third intermediate layer pattern that is arranged between the first intermediate layer pattern and the second intermediate layer pattern in such a manner as to face the first intermediate layer pattern and the second intermediate layer pattern, and that has a region other than vias that do not include a via set to a ground potential as a ground layer.

9. The semiconductor device according to any one of claims 1 to 2, wherein
the first semiconductor element (10) is a semiconductor element having a high output amplification function,
the second semiconductor element (20) is a semiconductor element having a power supply control function, and
the third back-side pad of the third substrate (300) is formed on a back surface of a single-layer insulating substrate, and the third front-side pad of the third substrate (300) is formed on a front surface of the single-layer insulating substrate.

10. The semiconductor device according to any one of claims 1 to 2, wherein
the first semiconductor element (10) is a semiconductor element having a high output amplification function, two output terminals, and a characteristic impedance of a 100 Ω system,
an output synthesis circuit (105) including a first transmission line (106) and a second transmission line (107) connected in series between an output node and one of the output terminals of the first semiconductor element (10), and a third transmission line (108) connected between the output node and the other of the output terminals of the first semiconductor element (10) is formed in the first wiring pattern layer in the first substrate (100), and
a characteristic impedance of each of the first transmission line (106), the second transmission line (107), and the third transmission line (108) is 100 Ω, and an electrical length of each of the first transmission line (106), the second transmission line (107), and the third transmission line (108) is 50 degrees to 90 degrees.

11. The semiconductor device according to claim 10, wherein
the second semiconductor element (20) is a semiconductor element having a power supply control function.

12. The semiconductor device according to claim 11, further comprising a third semiconductor element (30) having a driver amplification function, the third semiconductor element (30) being mounted and fixed on the front surface of the second base portion (230) of the second substrate (200) via the second heat sink (20A) in the second opening (202) of the second substrate (200), and electrically connected to the line constituting the second wiring pattern layer of the second substrate (200).

13. The semiconductor device according to claim 10, further comprising a heat radiator (400) mounted on a back surface of the first base portion (130) in the first substrate (100).

14. The semiconductor device according to any one of claims 1 to 2, wherein
the first semiconductor element (10) is a semiconductor element having a high output amplification function,
the second semiconductor element (20) is a semiconductor element having a power supply control function,
the plurality of first front-side pads on the first substrate (100) is arranged around the first insulating substrate (101) in such a manner as to surround the first wiring pattern,
at least one of the plurality of second front-side pads on the second substrate (200) is arranged in a central portion of the front surface of the second insulating substrate (201), and
the remaining second front-side pads are arranged around the second insulating substrate (201) in such a manner as to surround the second wiring pattern.

## Patentansprüche

1. Halbleiterbauelement umfassend:
ein erstes Substrat (100), aufweisend ein erstes isolierendes Substrat (101), eine erste Verdrahtungsmusterschicht und eine Vielzahl von ersten vorderseitigen Pads, die auf einer vorderen Fläche des ersten isolierenden Substrats (101) ausgebildet sind, und einen ersten Basisabschnitt (130), der aus Kupfer aufgebaut ist, das eine Dicke von 100 µm oder mehr aufweist, und auf einer hinteren Fläche des ersten isolierenden Substrats (101) ausgebildet ist, wobei eine erste Öffnung (102), die eine vordere Fläche des ersten Basisabschnitts (130) von der vorderen Fläche aus erreicht, in dem ersten isolierenden Substrat (101) ausgebildet ist;
ein erstes Halbleiterelement (10), das auf der vorderen Fläche des ersten Basisabschnitts (130) des ersten Substrats (100) über einen ersten Kühlkörper (10A) in der ersten Öffnung (102) des ersten Substrats (100) montiert und befestigt ist und elektrisch mit einer Leitung verbunden ist, die in der ersten Verdrahtungsmusterschicht des ersten Substrats (100) implementiert ist, wobei die Leitung mit einer der Vielzahl von ersten vorderseitigen Pads verbunden ist;
ein zweites Substrat (200), aufweisend ein zweites isolierendes Substrat (201), eine zweite Verdrahtungsmusterschicht und eine Vielzahl von zweiten vorderseitigen Pads, die auf einer vorderen Fläche des zweiten isolierenden Substrats (201) ausgebildet sind, und einen zweiten Basisabschnitt (230), der aus Kupfer aufgebaut ist, das eine Dicke von 100 µm oder mehr aufweist, und auf einer hinteren Fläche des zweiten isolierenden Substrats (201) ausgebildet ist, wobei eine zweite Öffnung (202), die eine vordere Fläche des zweiten Basisabschnitts (230) von der vorderen Fläche aus erreicht, in dem zweiten isolierenden Substrat (201) ausgebildet ist;
ein zweites Halbleiterelement (20), das auf der vorderen Fläche des zweiten Basisabschnitts (230) des zweiten Substrats (200) über einen zweiten Kühlkörper (20A) in der zweiten Öffnung (202) des zweiten Substrats (200) montiert und befestigt ist und elektrisch mit einer Leitung verbunden ist, die in der zweiten Verdrahtungsmusterschicht des zweiten Substrats (200) implementiert ist, wobei die Leitung mit einer der Vielzahl von zweiten vorderseitigen Pads verbunden ist; und
ein drittes Substrat (300), das eine elektrische Verbindung zwischen dem ersten Substrat (100) und dem zweiten Substrat (200) weiterleitet, angeordnet zwischen dem ersten Substrat (100) und dem zweiten Substrat (200), so dass es dem ersten Substrat (100) und dem zweiten Substrat (200) zugewandt ist, wobei das dritte Substrat (300) eine Vielzahl von dritten rückseitigen Pads auf einer hinteren Fläche davon aufweist, wobei jedes der dritten rückseitigen Pads mit einem entsprechenden der Vielzahl von ersten vorderseitigen Pads des ersten Substrats (100) durch ein Verbindungselement (50) verbunden ist, und eine Vielzahl von dritten vorderseitigen Flächen auf einer vorderen Fläche davon aufweist, wobei jedes der dritten vorderseitigen Pads mit einem entsprechenden der Vielzahl von zweiten vorderseitigen Pads des zweiten Substrats (200) durch ein Verbindungselement (70) verbunden ist; wobei das dritte Substrat (300) eine Grundschicht aufweist, die ein festes Muster auf jeder der vorderen Fläche und der hinteren Fläche ist.

2. Halbleitereinrichtung nach Anspruch 1, wobei
das erste isolierende Substrat (101) in dem ersten Substrat (100) und das zweite isolierende Substrat (201) in dem zweiten Substrat (200) aus demselben Material aufgebaut sind und diesselbe Dicke aufweisen,
die erste Verdrahtungsmusterschicht in dem ersten Substrat (100) und die zweite Verdrahtungsmusterschicht in dem zweiten Substrat (200) aus demselben Material aufgebaut sind und dieselbe Dicke aufweisen, und
der erste Basisabschnitt (130) in dem ersten Substrat (100) und der zweite Basisabschnitt (230) in dem zweiten Substrat (200) aus demselben Material aufgebaut sind und diesselbe Dicke aufweisen.

3. Halbleitereinrichtung nach einem der Ansprüche 1 bis 2, wobei
das erste Halbleiterelement (10) ein Halbleiterelement mit einer hohen Ausgangsverstärkungsfunktion ist,
das zweite Halbleiterelement (20) ein Halbleiterelement mit einer Energieversorgungssteuerfunktion ist, und
das dritte Substrat (300) ein Substrat ist, das die elektrische Verbindung zwischen dem ersten Substrat (100) und dem zweiten Substrat (200) weiterleitet.

4. Halbleiterelement nach Anspruch 3, ferner umfassend ein drittes Halbleiterelement (30) mit einer Treiberverstärkungsfunktion, wobei das dritte Halbleiterelement (30) auf der vorderen Fläche des zweiten Basisabschnitts (230) des zweiten Substrats (200) über den zweiten Kühlkörper (20A) in der zweiten Öffnung (202) des zweiten Substrats (200) montiert und befestigt ist und elektrisch mit der Leitung verbunden ist, die die zweite Verdrahtungsmusterschicht des zweiten Substrats (200) aufbaut.

5. Halbleitereinrichtung nach einem der Ansprüche 1 bis 2, wobei
das erste Halbleiterelement (10) ein Halbleiterelement mit einer hohen Ausgangsverstärkungsfunktion ist,
das zweite Halbleiterelement (20) ein Halbleiterelement mit einer Energieversorgungssteuerfunktion ist,
mindestens eines der Vielzahl von zweiten vorderseitigen Pads, die auf der vorderen Fläche des zweiten isolierenden Substrats (201) ausgebildet sind, in einem zentralen Abschnitt der vorderen Fläche des zweiten isolierenden Substrats (201) ausgebildet ist, und
das dritte Substrat (300) ein Substrat ist, das eine elektrische Verbindung zwischen einem in einem zentralen Abschnitt des zweiten Substrats (200) angeordneten vorderseitigen Pad und einem an einem Seitenabschnitt des zweiten Substrats (200) angeordneten vorderseitigen Pad weiterleitet.

6. Halbleiterelement nach Anspruch 5, ferner umfassend einen Wärmestrahler (400), der auf einer hinteren Fläche des ersten Basisabschnitts (130) in dem ersten Substrat (100) montiert ist.

7. Halbleitereinrichtung nach einem der Ansprüche 1 bis 2, wobei
das dritte Substrat (300) ein Zwischenschichtmuster zwischen dem festen Muster auf der vorderen Fläche und dem festen Muster auf der hinteren Fläche aufweist; und
das Zwischenschichtmuster einen Verdrahtungspfad zum elektrischen Verbinden eines dritten vorderseitigen Pads der dritten vorderseitigen Pads und des dritten rückseitigen Pads der dritten rückseitigen Pads entsprechend dem dritten vorderseitigen Pad aufweist.

8. Halbleitereinrichtung nach Anspruch 7, wobei
das Zwischenschichtmuster ein erstes Zwischenschichtmuster und ein zweites Zwischenschichtmuster umfasst, die einander zugewandt angeordnet sind, und
ein drittes Zwischenschichtmuster, das zwischen dem ersten Zwischenschichtmuster und dem zweiten Zwischenschichtmuster so angeordnet ist, dass es dem ersten Zwischenschichtmuster und dem zweiten Zwischenschichtmuster zugewandt ist, und das einen anderen Bereich als Durchkontaktierungen, die keine auf ein Massepotential eingestellte Durchkontaktierung umfassen, als Masseschicht aufweist.

9. Halbleitereinrichtung nach einem der Ansprüche 1 bis 2, wobei
das erste Halbleiterelement (10) ein Halbleiterelement mit einer hohen Ausgangsverstärkungsfunktion ist,
das zweite Halbleiterelement (20) ein Halbleiterelement mit einer Energieversorgungssteuerfunktion ist, und
das dritte rückseitige Pad des dritten Substrats (300) auf einer hinteren Fläche eines einschichtigen isolierenden Substrats ausgebildet ist, und das dritte vorderseitige Pad des dritten Substrats (300) auf einer vorderen Fläche des einschichtigen isolierenden Substrats ausgebildet ist.

10. Halbleitereinrichtung nach einem der Ansprüche 1 bis 2, wobei
das erste Halbleiterelement (10) ein Halbleiterelement mit einer hohen Ausgangsverstärkungsfunktion, zwei Ausgangsanschlüssen und einer charakteristischen Impedanz eines 100-Ω-Systems ist,
eine Ausgangssyntheseschaltung (105), aufweisend eine erste Übertragungsleitung (106) und eine zweite Übertragungsleitung (107), die zwischen einem Ausgangsknoten und einem der Ausgangsanschlüsse des ersten Halbleiterelements (10) in Reihe geschaltet sind, und eine dritte Übertragungsleitung (108), die zwischen dem Ausgangsknoten und dem anderen der Ausgangsanschlüsse des ersten Halbleiterelements (10) geschaltet ist, in der ersten Verdrahtungsmusterschicht in dem ersten Substrat (100) ausgebildet ist, und
eine charakteristische Impedanz jeder der ersten Übertragungsleitung (106), der zweiten Übertragungsleitung (107) und der dritten Übertragungsleitung (108) 100 Ω beträgt, und eine elektrische Länge jeder der ersten Übertragungsleitung (106), der zweiten Übertragungsleitung (107) und der dritten Übertragungsleitung (108) 50 Grad bis 90 Grad beträgt.

11. Halbleitereinrichtung nach Anspruch 10, wobei
das zweite Halbleiterelement (20) ein Halbleiterelement mit einer Energieversorgungssteuerfunktion ist.

12. Halbleiterelement nach Anspruch 11, ferner umfassend ein drittes Halbleiterelement (30) mit einer Treiberverstärkungsfunktion, wobei das dritte Halbleiterelement (30) auf der vorderen Fläche des zweiten Basisabschnitts (230) des zweiten Substrats (200) über den zweiten Kühlkörper (20A) in der zweiten Öffnung (202) des zweiten Substrats (200) montiert und befestigt ist und elektrisch mit der Leitung verbunden ist, die die zweite Verdrahtungsmusterschicht des zweiten Substrats (200) aufbaut.

13. Halbleiterelement nach Anspruch 10, ferner umfassend einen Wärmestrahler (400), der auf einer hinteren Fläche des ersten Basisabschnitts (130) in dem ersten Substrat (100) montiert ist.

14. Halbleitereinrichtung nach einem der Ansprüche 1 bis 2, wobei
das erste Halbleiterelement (10) ein Halbleiterelement mit einer hohen Ausgangsverstärkungsfunktion ist,
das zweite Halbleiterelement (20) ein Halbleiterelement mit einer Energieversorgungssteuerfunktion ist,
die Vielzahl von ersten vorderseitigen Pads auf dem ersten Substrat (100) so um das erste isolierende Substrat (101) herum angeordnet sind, dass sie das erste Verdrahtungsmuster umgeben,
mindestens eines der Vielzahl von zweiten vorderseitigen Pads auf dem zweiten Substrat (200) in einem zentralen Abschnitt der vorderen Fläche des zweiten isolierenden Substrats (201) ausgebildet ist, und
die verbleibenden zweiten vorderseitigen Pads so um das zweite isolierende Substrat (201) angeordnet sind, dass sie das zweite Verdrahtungsmuster umgeben.

## Revendications

1. Dispositif à semi-conducteur, comprenant :
un premier substrat (100) incluant un premier substrat isolant (101), une première couche de motif de câblage et une pluralité de premiers plots côté avant formés sur une surface avant du premier substrat isolant (101), et une première partie de base (130) constituée de cuivre présentant une épaisseur de 100 µm ou plus et formée sur une surface arrière du premier substrat isolant (101), dans lequel une première ouverture (102) atteignant une surface avant de la première partie de base (130) à partir de la surface avant est formée dans le premier substrat isolant (101) ;
un premier élément semi-conducteur (10) monté et fixé sur la surface avant de la première partie de base (130) du premier substrat (100) via un premier dissipateur thermique (10A) dans la première ouverture (102) du premier substrat (100), et connecté électriquement à une ligne mise en œuvre dans la première couche de motif de câblage du premier substrat (100), la ligne étant connectée à l'un de la pluralité de premiers plots côté avant ;
un deuxième substrat (200) incluant un deuxième substrat isolant (201), une seconde couche de motif de câblage et une pluralité de deuxièmes plots côté avant formés sur une surface avant du deuxième substrat isolant (201), et une seconde partie de base (230) constituée de cuivre présentant une épaisseur de 100 µm ou plus et formée sur une surface arrière du deuxième substrat isolant (201), dans lequel une seconde ouverture (202) atteignant une surface avant de la seconde partie de base (230) à partir de la surface avant est formée dans le deuxième substrat isolant (201) ;
un deuxième élément semi-conducteur (20) monté et fixé sur la surface avant de la seconde partie de base (230) du deuxième substrat (200) via un second dissipateur thermique (20A) dans la seconde ouverture (202) du deuxième substrat (200), et connecté électriquement à une ligne mise en œuvre dans la seconde couche de motif de câblage du deuxième substrat (200), la ligne étant connectée à l'un de la pluralité de deuxièmes plots côté avant ; et
un troisième substrat (300), qui relaie la connexion électrique entre le premier substrat (100) et le deuxième substrat (200), agencé entre le premier substrat (100) et le deuxième substrat (200) de manière à faire face au premier substrat (100) et au deuxième substrat (200), le troisième substrat (300) incluant une pluralité de troisièmes plots côté arrière sur une surface arrière de celui-ci, chacun des troisièmes plots côté arrière étant connecté à un correspondant de la pluralité de premiers plots côté avant du premier substrat (100) par un élément de connexion (50), et une pluralité de troisièmes plots côté avant sur une surface avant de celui-ci, chacun des troisièmes plots côté avant étant connecté à un correspondant de la pluralité de deuxièmes plots côté avant du deuxième substrat (200) par un organe de connexion (70) ; dans lequel le troisième substrat (300) présente une couche de masse qui est un motif solide sur chacune de la surface avant et de la surface arrière.

2. Dispositif à semi-conducteur selon la revendication 1, dans lequel
le premier substrat isolant (101) dans le premier substrat (100) et le deuxième substrat isolant (201) dans le deuxième substrat (200) sont constitués d'un même matériau et présentent une même épaisseur,
la première couche de motif de câblage dans le premier substrat (100) et la seconde couche de motif de câblage dans le deuxième substrat (200) sont constituées d'un même matériau et présentent une même épaisseur, et
la première partie de base (130) dans le premier substrat (100) et la seconde partie de base (230) dans le deuxième substrat (200) sont constituées d'un même matériau et présentent une même épaisseur.

3. Dispositif à semi-conducteur selon l'une quelconque des revendications 1 à 2 ; dans lequel
le premier élément semi-conducteur (10) est un élément semi-conducteur présentant une fonction d'amplification de sortie élevée,
le deuxième élément semi-conducteur (20) est un élément semi-conducteur présentant une fonction de commande d'alimentation électrique, et
le troisième substrat (300) est un substrat qui relaie la connexion électrique entre le premier substrat (100) et le deuxième substrat (200).

4. Dispositif à semi-conducteur selon la revendication 3, comprenant en outre un troisième élément semi-conducteur (30) présentant une fonction d'amplification de pilote, le troisième élément semi-conducteur (30) étant monté et fixé sur la surface avant de la seconde partie de base (230) du deuxième substrat (200) via le second dissipateur thermique (20A) dans la seconde ouverture (202) du deuxième substrat (200), et connecté électriquement à la ligne constituant la seconde couche de motif de câblage du deuxième substrat (200).

5. Dispositif à semi-conducteur selon l'une quelconque des revendications 1 à 2 ; dans lequel
le premier élément semi-conducteur (10) est un élément semi-conducteur présentant une fonction d'amplification de sortie élevée,
le deuxième élément semi-conducteur (20) est un élément semi-conducteur présentant une fonction de commande d'alimentation électrique,
au moins un de la pluralité de deuxièmes plots côté avant formés sur la surface avant du deuxième substrat isolant (201) est agencé dans une partie centrale de la surface avant du deuxième substrat isolant (201), et
le troisième substrat (300) est un substrat qui relaie une connexion électrique entre un plot côté avant agencé dans une partie centrale du deuxième substrat (200) et un plot côté avant agencé au niveau d'une partie latérale du deuxième substrat (200).

6. Dispositif à semi-conducteur selon la revendication 5, comprenant en outre un radiateur de chaleur (400) monté sur une surface arrière de la première partie de base (130) dans le premier substrat (100).

7. Dispositif à semi-conducteur selon l'une quelconque des revendications 1 à 2 ; dans lequel
le troisième substrat (300) présente un motif de couche intermédiaire entre le motif solide sur la surface avant et le motif solide sur la surface arrière, et
le motif de couche intermédiaire inclut un trajet de câblage pour connecter électriquement un troisième plot côté avant des troisièmes plots côté avant et le troisième plot côté arrière des troisièmes plots côté arrière correspondant au troisième plot côté avant.

8. Dispositif à semi-conducteur selon la revendication 7, dans lequel
le motif de couche intermédiaire inclut un premier motif de couche intermédiaire et un deuxième motif de couche intermédiaire qui sont agencés pour se faire face mutuellement, et
un troisième motif de couche intermédiaire qui est agencé entre le premier motif de couche intermédiaire et le deuxième motif de couche intermédiaire de manière à faire face au premier motif de couche intermédiaire et au deuxième motif de couche intermédiaire, et qui présente une région autre que des trous d'interconnexion qui n'incluent pas un trou d'interconnexion réglé à un potentiel de masse en tant que couche de masse.

9. Dispositif à semi-conducteur selon l'une quelconque des revendications 1 à 2 ; dans lequel
le premier élément semi-conducteur (10) est un élément semi-conducteur présentant une fonction d'amplification de sortie élevée,
le deuxième élément semi-conducteur (20) est un élément semi-conducteur présentant une fonction de commande d'alimentation électrique, et
le troisième plot côté arrière du troisième substrat (300) est formé sur une surface arrière d'un substrat isolant monocouche, et le troisième plot côté avant du troisième substrat (300) est formé sur une surface avant du substrat isolant monocouche.

10. Dispositif à semi-conducteur selon l'une quelconque des revendications 1 à 2 ; dans lequel
le premier élément semi-conducteur (10) est un élément semi-conducteur présentant une fonction d'amplification de sortie élevée, deux bornes de sortie et une impédance caractéristique d'un système de 100 Ω,
un circuit de synthèse de sortie (105) comprenant une première ligne de transmission (106) et une deuxième ligne de transmission (107) connectées en série entre un nœud de sortie et l'une des bornes de sortie du premier élément semi-conducteur (10), et une troisième ligne de transmission (108) connectée entre le nœud de sortie et l'autre des bornes de sortie du premier élément semi-conducteur (10) est formée dans la première couche de motif de câblage dans le premier substrat (100), et
une impédance caractéristique de chacune de la première ligne de transmission (106), de la deuxième ligne de transmission (107) et de la troisième ligne de transmission (108) est de 100 Ω, et une longueur électrique de chacune de la première ligne de transmission (106), de la deuxième ligne de transmission (107) et de la troisième ligne de transmission (108) est de 50 degrés à 90 degrés.

11. Dispositif à semi-conducteur selon la revendication 10, dans lequel
le deuxième élément semi-conducteur (20) est un élément semi-conducteur présentant une fonction de commande d'alimentation électrique.

12. Dispositif à semi-conducteur selon la revendication 11, comprenant en outre un troisième élément semi-conducteur (30) présentant une fonction d'amplification de pilote, le troisième élément semi-conducteur (30) étant monté et fixé sur la surface avant de la seconde partie de base (230) du deuxième substrat (200) via le second dissipateur thermique (20A) dans la seconde ouverture (202) du deuxième substrat (200), et connecté électriquement à la ligne constituant la seconde couche de motif de câblage du deuxième substrat (200).

13. Dispositif à semi-conducteur selon la revendication 10, comprenant en outre un radiateur de chaleur (400) monté sur une surface arrière de la première partie de base (130) dans le premier substrat (100).

14. Dispositif à semi-conducteur selon l'une quelconque des revendications 1 à 2 ; dans lequel
le premier élément semi-conducteur (10) est un élément semi-conducteur présentant une fonction d'amplification de sortie élevée,
le deuxième élément semi-conducteur (20) est un élément semi-conducteur présentant une fonction de commande d'alimentation électrique,
la pluralité de premiers plots avant sur le premier substrat (100) est agencée autour du premier substrat isolant (101) de manière à entourer le premier motif de câblage,
au moins un de la pluralité de deuxièmes plots côté avant sur le deuxième substrat (200) est agencé dans une partie centrale de la surface avant du deuxième substrat isolant (201), et
les deuxièmes plots côté avant sont agencés autour du deuxième substrat isolant (201) de manière à entourer le second motif de câblage.
